(19) Europäisches Patentamt / European Patent Office / Office européen des brevets

(11) **EP 3 896 966 B1**

(12) **EUROPEAN PATENT SPECIFICATION**

(45) Date of publication and mention
of the grant of the patent:
**04.09.2024   Bulletin 2024/36**

(21) Application number: **19896205.2**

(22) Date of filing: **14.11.2019**

(51) International Patent Classification (IPC):
*H01L 27/146* (2006.01)    *H04N 25/131* (2023.01)
*H04N 25/133* (2023.01)    *H04N 25/585* (2023.01)
*H04N 25/771* (2023.01)    *H04N 25/778* (2023.01)

(52) Cooperative Patent Classification (CPC):
**H01L 27/14614; H01L 27/14605; H01L 27/14607;
H01L 27/1461; H01L 27/14623; H01L 27/14645;
H04N 25/131; H04N 25/133; H04N 25/585;
H04N 25/771; H04N 25/778**

(86) International application number:
**PCT/JP2019/044650**

(87) International publication number:
**WO 2020/121724 (18.06.2020 Gazette 2020/25)**

(54) **SOLID-STATE IMAGING DEVICE AND ELECTRONIC INSTRUMENT**

BILDERZEUGENDE FESTKÖRPERVORRICHTUNG UND ELEKTRONISCHES INSTRUMENT

DISPOSITIF D'IMAGERIE À SEMI-CONDUCTEUR ET INSTRUMENT ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.12.2018   JP 2018232003**

(43) Date of publication of application:
**20.10.2021   Bulletin 2021/42**

(73) Proprietor: **Sony Semiconductor Solutions
Corporation
Atsugi-shi, Kanagawa 243-0014 (JP)**

(72) Inventors:
• **IIDA, Satoko**
**Atsugi-shi, Kanagawa 243-0014 (JP)**
• **SUZUKI, Atsushi**
**Atsugi-shi, Kanagawa 243-0014 (JP)**
• **SAKANO, Yorito**
**Atsugi-shi, Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(56) References cited:
WO-A1-2017/154605    WO-A1-2018/096955
JP-A- 2005 286 565    JP-A- 2009 027 289
JP-A- 2009 130 574    JP-A- 2011 015 219
JP-A- 2011 130 022    JP-A- 2013 207 035
US-A1- 2011 140 182

**Description**

TECHNICAL FIELD

The present disclosure relates to a solid-state imaging device and an electronic device.

BACKGROUND ART

In an imaging device including a photoelectric conversion element, for example, it is desirable that the sensitivity of the photoelectric conversion element is high in a case where the illuminance is low, and it is desirable that the photoelectric conversion element is not easily saturated in a case where the illuminance is high.

Thus, for example, in Patent Document 1, a technology is disclosed in which two large and small photoelectric conversion elements having different areas are arranged in a unit pixel, and a dimming portion is provided in the small-area photoelectric conversion element, whereby the two photoelectric conversion elements having different areas have a sensitivity difference greater than or equal to an area difference.

Patent Document 2 discloses a solid-state imaging device which includes an area and color filters. The area includes pixels. Each of the pixels includes a first photodiode, a first read transistor, a second photodiode, a second read transistor, a floating diffusion, a reset transistor, and an amplifying transistor. The first photodiode performs photoelectric conversion. The first read transistor reads a signal charge. The second photodiode has a photosensitivity lower than the first photodiode. The second read transistor reads a signal charge. The floating diffusion stores the signal charges. The reset transistor resets a potential of the floating diffusion. The amplifying transistor amplifies the potential of the floating diffusion. The color filters include a first and a second filters.

Patent Document 3 discloses an imaging device and an electronic equipment that make it possible to enlarge the dynamic range of the imaging device without degrading the image quality.

CITATION LIST

PATENT DOCUMENT

Patent Document 1: Japanese Patent Application Laid-Open No. 2017-163010
Patent Document 2: US 2011/140182 A1
Patent Document 3: WO 2017/154605 A1

SUMMARY OF THE INVENTION

PROBLEMS TO BE SOLVED BY THE INVENTION

However, in a case where photoelectric conversion elements having different sensitivities are provided as in the conventional technology described above, if the high-sensitivity large-area photoelectric conversion element is saturated and then further irradiated with light continuously, a phenomenon called blooming occurs in which a charge leaks from the antecedently saturated large-area photoelectric conversion element to a small-area photoelectric conversion element that is not yet saturated. The charge flowing into the small-area photoelectric conversion element due to the blooming appears as noise in an output signal read from the photoelectric conversion element. As a result, Photo Response Non-Uniformity (PRNU) degrades, and a problem is caused that image quality degrades.

Thus, in the present disclosure, a solid-state imaging device and an electronic device are devised that are enabled to suppress degradation of image quality.

SOLUTIONS TO PROBLEMS

To solve the problem described above, a solid-state imaging device according to claim 1 as the main embodiment. The appended dependent claims define further embodiments.

BRIEF DESCRIPTION OF DRAWINGS

Fig. 1 is a block diagram illustrating a schematic configuration example of a CMOS image sensor according to a first embodiment.

Fig. 2 is a circuit diagram illustrating a schematic configuration example of a unit pixel according to the first embodiment.

Fig. 3 is a schematic diagram illustrating a planar layout example of unit pixels according to the first embodiment.

Fig. 4 is a schematic diagram illustrating the planar layout example of the unit pixels according to the first embodiment, and is a schematic diagram in which a planar layout on a second surface of a silicon substrate and a planar layout on a first surface are superimposed on each other.

Fig. 5 is a schematic diagram illustrating the planar layout example of the unit pixels according to the first embodiment, and is a diagram in which a planar layout is extracted of a first photoelectric conversion element, a second photoelectric conversion element, a first on-chip lens, and a second on-chip lens on the first surface, from Fig. 4.

Fig. 6 is a schematic diagram illustrating the planar layout example of the unit pixels according to the first embodiment, and is a diagram in which a planar layout is extracted of an inter-pixel light shielding portion provided between the pixels on the first surface of the unit pixel, in addition to the first photoelectric conversion element, the second photoelectric conversion element, the first on-chip lens, and the second on-chip lens on the first surface illustrated in Fig. 5.

Fig. 7 is a plan view illustrating a planar layout example of a color filter array according to the first embodiment.

Fig. 8 is a diagram illustrating an example of a Bayer array according to the first embodiment.

Fig. 9 is a diagram illustrating an example of an X-Trans type color filter array according to the first embodiment.

Fig. 10 is a diagram illustrating an example of a quad Bayer array according to the first embodiment.

Fig. 11 is a diagram illustrating an example of a white RGB gata color filter array according to the first embodiment.

Fig. 12 is a diagram for explaining an outflow destination of a leakage current from a large pixel in the unit pixel according to the first embodiment.

Fig. 13 is a cross-sectional view illustrating a schematic configuration example of a charge storage part according to the first embodiment.

Fig. 14 is a schematic diagram illustrating a planar layout example of unit pixels according to a second embodiment.

Fig. 15 is a schematic diagram illustrating a planar layout example of unit pixels according to a third embodiment.

Fig. 16 is a plan view illustrating a planar layout example of a color filter array according to a fourth embodiment.

Fig. 17 is a plan view illustrating a planar layout example of a color filter array according to a first example of a fifth embodiment.

Fig. 18 is a plan view illustrating a planar layout example of a color filter array according to a second example of the fifth embodiment.

Fig. 19 is a plan view illustrating a planar layout example of a color filter array according to a third example of the fifth embodiment.

Fig. 20 is a plan view illustrating a planar layout example of a color filter array according to a fourth example of the fifth embodiment.

Fig. 21 is a plan view illustrating a planar layout example of a color filter array according to a fifth example of the fifth embodiment.

Fig. 22 is a plan view illustrating a planar layout example of a color filter array according to a sixth example of the fifth embodiment.

Fig. 23 is a plan view illustrating a planar layout example of a color filter array according to a seventh example of the fifth embodiment.

Fig. 24 is a plan view illustrating a planar layout example of a color filter array according to an eighth example of the fifth embodiment.

Fig. 25 is a plan view illustrating a planar layout example of a color filter array according to a ninth example of the fifth embodiment.

Fig. 26 is a plan view illustrating a planar layout example of a color filter array according to a tenth example of the fifth embodiment.

Fig. 27 is a plan view illustrating a planar layout example of a color filter array according to an eleventh example of the fifth embodiment.

Fig. 28 is a plan view illustrating a planar layout example of a color filter array according to a twelfth example of the fifth embodiment.

Fig. 29 is a plan view illustrating a planar layout example of a color filter array according to a thirteenth example of the fifth embodiment.

Fig. 30 is a plan view illustrating a planar layout example of a color filter array according to a fourteenth example of a fifth embodiment.

Fig. 31 is a plan view illustrating a planar layout example of a color filter array according to a fifteenth example of the fifth embodiment.

Fig. 32 is a block diagram illustrating an example of a schematic configuration of a vehicle control system.

Fig. 33 is an explanatory diagram illustrating an example of installation positions of a vehicle exterior information detecting unit and an imaging unit.

MODE FOR CARRYING OUT THE INVENTION

Hereinafter, one embodiment of the present disclosure will be described in detail on the basis of the drawings. Note that, in the following embodiments, the same parts are designated by the same reference numerals, whereby duplicate description will be omitted.

Furthermore, the present disclosure will be described in accordance with the order of items indicated below.

1. First embodiment
1.1 CMOS image sensor
1.2 Unit pixel
1.3 Planar layout of unit pixels
1.3.1 Planar layout of second surface
1.3.2 Planar layout of first surface and second surface
1.4 Planar layout of color filters
1.4.1 Planar layout of color filters for large pixels
1.4.2 Planar layout of color filters for small pixels
1.4.2.1 Outflow destination of leakage current from large pixel
1.4.2.2 Combination of large pixel and small pixel
1.5 Function and effect
2. Second embodiment
2.1 Function and effect
3. Third embodiment
3.1 Function and effect
4. Fourth embodiment
4.1 Example of color filter array
4.2 Function and effect
5. Fifth embodiment
5.1 First example
5.2 Second example
5.3 Third example
5.4 Fourth example
5.5 Fifth example
5.6 Sixth example
5.7 Seventh example
5.8 Eighth example
5.9 Ninth example
5.10 Tenth example
5.11 Eleventh example
5.12 Twelfth example
5.13 Thirteenth example
5.14 Fourteenth example
5.15 Fifteenth example
5.16 Function and effect
6. Sixth embodiment
7. Application example to mobile body

1. First embodiment

First, a solid-state imaging device and an electronic device according to a first embodiment will be described in detail with reference to the drawings.

1.1 CMOS image sensor

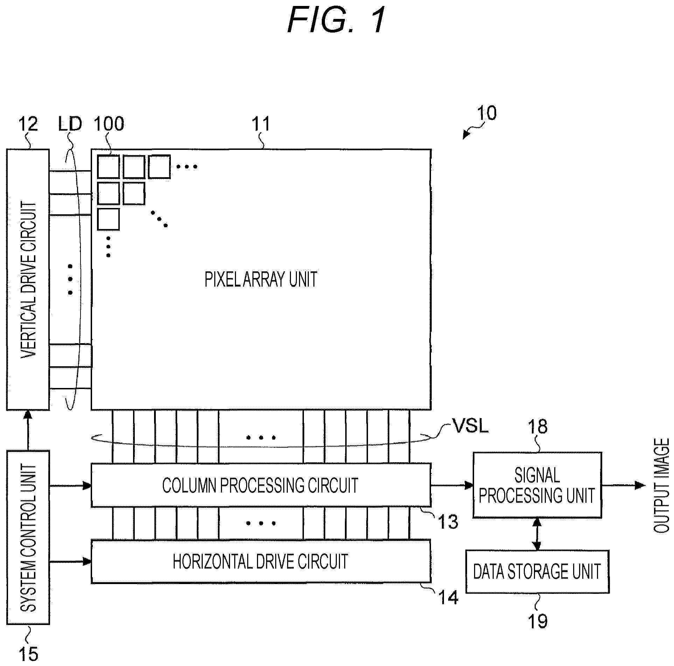

Fig. 1 is a block diagram illustrating a schematic configuration example of a Complementary Metal-Oxide-Semiconductor (CMOS) type solid-state imaging device (hereinafter, simply referred to as a CMOS image sensor) according to the first embodiment. Here, the CMOS image sensor is an image sensor created by applying or partially using a CMOS process. For example, a CMOS image sensor 10 according to the present embodiment includes a backside illumination type CMOS image sensor.

The CMOS image sensor 10 according to the present embodiment has, for example, stack structure in which a semiconductor chip on which a pixel array unit 11 is formed and a semiconductor chip on which peripheral circuits are formed are stacked together. The peripheral circuits may include, for example, a vertical drive circuit 12, a column processing circuit 13, a horizontal drive circuit 14, and a system control unit 15.

The CMOS image sensor 10 further includes a signal processing unit 18 and a data storage unit 19. The signal processing unit 18 and the data storage unit 19 may be provided on the same semiconductor chip as the peripheral circuits, or may be provided on another semiconductor chip.

The pixel array unit 11 has a configuration in which unit pixels (hereinafter, may also be simply referred to as "pixels") including a photoelectric conversion element that generates and stores charge depending on the amount of light received are arranged in the row direction and the column direction, that is, in a two-dimensional lattice in a matrix shape. Here, the row direction refers to an arrangement direction of the pixels of pixel rows (in other words, the horizontal direction), and the column direction refers to an arrangement direction of the pixels of pixel columns (in other words, the vertical direction). A specific circuit configuration of the unit pixel and details of pixel structure will be described later.

In the pixel array unit 11, to a matrix-shaped pixel array, a pixel drive line LD is wired along the row direction for each pixel row, and a vertical signal line VSL is wired along the column direction for each pixel column. The pixel drive line LD transmits a drive signal for performing drive at the time of reading a signal from each of the pixels. In Fig. 1, the pixel drive line LD is illustrated as one wiring line, but the wiring line is not limited to one wiring line. One end of the pixel drive line LD is connected to an output end corresponding to each row of the vertical drive circuit 12.

The vertical drive circuit 12 includes a shift register, an address decoder, and the like, and drives each pixel of the pixel array unit 11 at the same time for all pixels, or on a row basis or the like. That is, the vertical drive circuit 12, together with the system control unit 15 that controls the vertical drive circuit 12, constitutes a drive unit that controls operation of each pixel of the pixel array unit 11. Although its illustration of a specific configuration is omitted, the vertical drive circuit 12 generally includes two scanning systems, a read scanning system and a sweep scanning system.

The read scanning system performs selective scanning of the unit pixels of the pixel array unit 11 on a row basis in order to read a signal from the unit pixel. The signal read from the unit pixel is an analog signal. The sweep scanning system performs sweep scanning for a read row on which read scanning is performed by the read scanning system, prior to the read scanning by an exposure time.

By the sweep scanning by the sweep scanning system, unnecessary charge is swept from the photoelectric conversion element of the unit pixel of the read row, whereby the photoelectric conversion element is reset. Then, a so-called electronic shutter operation is performed by sweeping (resetting) unnecessary charge with this sweep scanning system. Here, the electronic shutter operation refers to operation of discarding the charge of the photoelectric conversion element and starting new exposure (starting storage of charge).

The signal read by read operation by the read scanning system corresponds to the amount of light received after the immediately preceding read operation or the electronic shutter operation. Then, a period from a read timing by the immediately preceding read operation or a sweep timing by the electronic shutter operation to a read timing by the current read operation is a charge storage period (also referred to as an exposure period) in the unit pixel.

The signal output from each unit pixel of the pixel row subjected to selective scanning by the vertical drive circuit 12 is input to the column processing circuit 13 through the individual vertical signal line VSL for each pixel column. The column processing circuit 13 performs predetermined signal processing on a signal output from each pixel in a selected row through the vertical signal line VSL for each pixel column of the pixel array unit 11, and temporarily holds a pixel signal after the signal processing.

Specifically, the column processing circuit 13 performs, as signal processing, at least noise removal processing, for example, Correlated Double Sampling (CDS) processing, or Double Data Sampling (DDS) processing. For example, the CDS processing removes reset noise and pixel-specific fixed pattern noises such as threshold value variation of the amplification transistor in the pixel. Besides, the column processing circuit 13 also has, for example, an analog-digital (AD) conversion function, and converts an analog pixel signal read and obtained from a photoelectric conversion element into a digital signal and outputs the signal.

The horizontal drive circuit 14 includes a shift register, an address decoder, and the like, and sequentially selects a read circuit (hereinafter, referred to as a pixel circuit) corresponding to a pixel column of the column processing circuit 13. By selective scanning by the horizontal drive circuit 14, the pixel signal is sequentially output that is subjected to the signal processing for each pixel circuit in the column processing circuit 13.

The system control unit 15 includes a timing generator that generates various timing signals, and the like, and performs drive control of the vertical drive circuit 12, the column processing circuit 13, the horizontal drive circuit 14, and the like, on the basis of the various timings generated by the timing generator.

The signal processing unit 18 has at least an arithmetic processing function, and performs various types of signal processing such as arithmetic processing on the pixel signal output from the column processing circuit 13. In the signal processing in the signal processing unit 18, the data storage unit 19 temporarily stores data necessary for the processing.

Note that, an output image output from the signal processing unit 18 may be subjected to execution of predetermined processing by an application processor or the like in an electronic device equipped with the CMOS image sensor 10, or transmitted to an external device via a predetermined network, for example.

1.2 Unit pixel

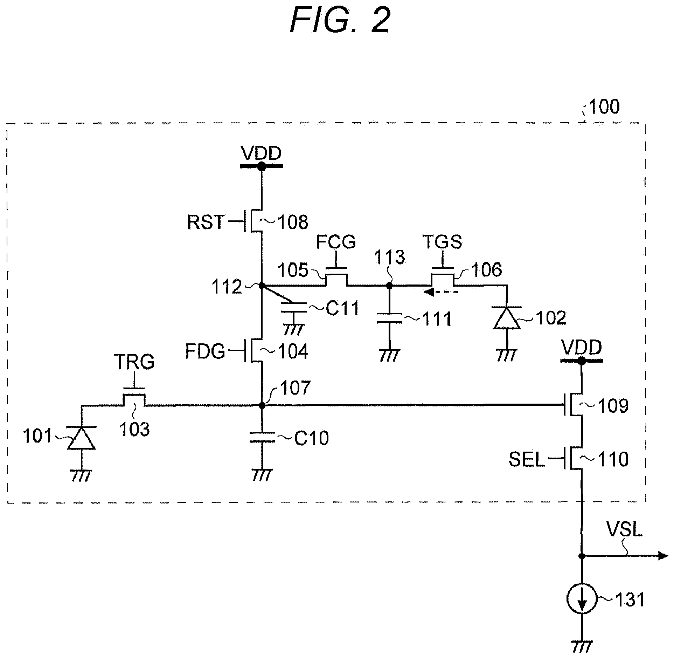

Fig. 2 is a circuit diagram illustrating a schematic configuration example of the unit pixel according to the present embodiment. As illustrated in Fig. 2, a unit pixel 100 includes a first photoelectric conversion element 101, a second photoelectric conversion element 102, a first transfer transistor 103, a second transfer transistor 104, a third transfer transistor 105, a fourth transfer transistor 106, a floating diffusion (FD) part 107, a reset transistor 108, an amplification transistor 109, and a selection transistor 110. The first transfer transistor 103 corresponds to, for example, a first transfer gate in the claims, and at least one of the second to fourth transfer transistors 104 to 106 corresponds to, for example, a second transfer gate in the claims. Furthermore, the amplification transistor 109 corresponds to, for example, an amplification gate in the claims, the selection transistor 110 corresponds to, for example, a selection gate in the claims, and the reset transistor 108 corresponds to, for example, a reset gate in the claims.

The first transfer transistor 103, the second transfer transistor 104, the third transfer transistor 105, the fourth transfer transistor 106, the reset transistor 108, the amplification transistor 109, and the selection transistor 110 are, for example, n-type MOS transistors (hereinafter referred to as NMOS transistors).

In the following description, the first transfer transistor 103, the second transfer transistor 104, the third transfer transistor 105, the fourth transfer transistor 106, the reset transistor 108, the amplification transistor 109, and the selection transistor 110 are also simply referred to as pixel transistors.

The reset transistor 108 and the amplification transistor 109 are connected to a power supply VDD. The first photoelectric conversion element 101 includes a so-called embedded type photodiode in which an n-type impurity region is formed inside a p-type impurity region formed on a silicon semiconductor substrate. Similarly, the second photoelectric conversion element 102 includes an embedded type photodiode. The first photoelectric conversion element 101 and the second photoelectric conversion element 102 generate charge depending on the amount of light received, and store the generated charge up to a certain amount.

Furthermore, the unit pixel 100 further includes a charge storage part 111. The charge storage part 111 is, for example, Metal-Oxide-Semiconductor (MOS) capacitance or Metal-Insulator-Semiconductor (MIS) capacitance.

In Fig. 2, between the first photoelectric conversion element 101 and the second photoelectric conversion element 102, the first transfer transistor 103, the second transfer transistor 104, the third transfer transistor 105, and the fourth transfer transistor 106 are connected together in series. A floating diffusion layer connected between the first transfer transistor 103 and the second transfer transistor 104 constitutes the FD part 107. The FD part 107 includes parasitic capacitance C10.

A floating diffusion layer connected between the second transfer transistor 104 and the third transfer transistor 105 constitutes a node 112. Node 112 includes parasitic capacitance C11. A floating diffusion layer connected between the third transfer transistor 105 and the fourth transfer transistor 106 constitutes a node 113. The charge storage part 111 is connected to the node 113.

For the unit pixel 100 illustrated in Fig. 2, as the pixel drive line LD described in Fig. 1, a plurality of drive lines is connected, for example, for each pixel row. Then, various drive signals TGL, FDG, FCG, TGS, RST, and SEL are supplied from the vertical drive circuit 12 via the plurality of drive lines. Note that, each of the drive signals TGL, FDG, FCG, TGS, RST, and SEL may be, for example, a pulse signal in which a high level (for example, a power supply voltage VDD) state is an active state and a low level state (for example, installation potential or negative potential) is an inactive state.

The drive signal TGL is applied to the gate electrode of the first transfer transistor 103. When the drive signal TGL is in the active state, the first transfer transistor 103 is in a conductive state, and the charge stored in the first photoelectric conversion element 101 is transferred to the FD part 107 via the first transfer transistor 103.

The drive signal FDG is applied to the gate electrode of the second transfer transistor 104. When the drive signal FDG is in the active state and thus the second transfer transistor 104 is in a conductive state, potentials of the FD part 107 and the node 112 are coupled, and one charge storage region is formed.

The drive signal FCG is applied to the gate electrode of the third transfer transistor 105. When the drive signal FDG and the drive signal FCG are in the active state and thus the second transfer transistor 104 and the third transfer transistor 105 are in a conductive states, potentials from the FD part 107 to the charge storage part 111 are coupled, and one charge storage region is formed.

The drive signal TGS is applied to the gate electrode of the fourth transfer transistor 106. When the drive signal TGS is in the active state, the fourth transfer transistor 106 is in a conductive state, and the charge stored in the second photoelectric conversion element 102 is transferred to the charge storage part 111 via the fourth transfer transistor 106. In a case where the fourth transfer transistor 106, the third transfer transistor 105, and the second transfer transistor 104 are in the active state, the potentials from the charge storage part 111 to the FD part 107 are coupled, and the charge stored in the second photoelectric conversion element 102 is transferred to the coupled charge storage region.

Moreover, a channel region below the gate electrode of the fourth transfer transistor 106 has a potential slightly shifted in a plus direction (in other words, the potential is slightly deeper) compared to that in, for example, a channel region below the gate electrode of the first transfer transistor 103, the second transfer transistor 104, or the third transfer transistor 105, whereby an overflow path for the charge is formed. As a result of photoelectric conversion in the second photoelectric conversion element 102, in a case where charge exceeding a saturated charge amount of the second photoelectric conversion element 102 is generated, the charge exceeding the saturated charge amount overflows (spills over) from the second photoelectric conversion element 102 to the charge storage part 111 via the overflow path. The overflowing charge is stored in the charge storage part 111.

Note that, in the following description, the overflow path formed in the channel region below the gate electrode of the fourth transfer transistor 106 is simply referred to as an overflow path of the fourth transfer transistor 106.

In Fig. 2, of two electrodes of the charge storage part 111, a first electrode is a node electrode connected to the node 113 between the third transfer transistor 105 and the fourth transfer transistor 106. Of the two electrodes of the charge storage part 111, a second electrode is a grounded electrode.

Note that, as a modification, the second electrode may be connected to a specific potential other than the ground potential, for example, a power supply potential.

In a case where the charge storage part 111 is the MOS capacitance or the MIS capacitance, as an example, the second electrode is an impurity region formed on a silicon substrate, and a dielectric film forming the capacitance is an oxide film or nitride film formed on the silicon substrate. The first electrode is an electrode including a conductive material, for example, polysilicon or metal, above the second electrode and the dielectric film.

In a case where the second electrode is set at the ground potential, the second electrode may be a p-type impurity region electrically connected to the p-type impurity region provided in the first photoelectric conversion element 101 or the second photoelectric conversion element 102. In a case where the second electrode is set at a specific potential other than the ground potential, the second electrode may be an n-type impurity region formed in the p-type impurity region.

In addition to the second transfer transistor 104, the reset transistor 108 is also connected to the node 112. A specific potential, for example, the power supply VDD is connected ahead of the reset transistor. The drive signal RST is applied to the gate electrode of the reset transistor 108. When the drive signal RST is in the active state, the reset transistor 108 is in a conductive state, and a potential of the node 112 is reset to a level of the voltage VDD.

When the drive signal FDG of the second transfer transistor 104 and the drive signal FCG of the third transfer transistor 105 are set in the active state at the time of setting the drive signal RST in the active state, a potential coupled among the node 112, the FD part 107, and the charge storage part 111 is reset to the level of the voltage VDD.

Note that, by controlling the drive signal FDG and the drive signal FCG individually, the potentials of the FD part 107 and the charge storage part 111 can be each reset alone (independently) to the level of the voltage VDD.

The FD part 107 that is a floating diffusion layer has a function of converting charge into a voltage. That is, when the charge is transferred to the FD part 107, the potential of the FD part 107 changes depending on the amount of the transferred charge.

The amplification transistor 109, in which a current source 131 connected to one end of the vertical signal line VSL is connected to the source side and a power supply VDD is connected to the drain side, forms a source follower circuit together with these. The FD part 107 is connected to the gate electrode of the amplification transistor 109, and serves as an input for the source follower circuit.

The selection transistor 110 is connected between the source of the amplification transistor 109 and the vertical signal line VSL. The drive signal SEL is applied to the gate electrode of the selection transistor 110. When the drive signal SEL is in the active state, the selection transistor 110 is in a conductive state, and the unit pixel 100 is in a selected state.

When the charge is transferred to the FD part 107, the potential of the FD part 107 becomes a potential corresponding to the amount of the transferred charge, and the potential is input to the source follower circuit described above. When the drive signal SEL is in the active state, the potential of the FD part 107 corresponding to the amount of the charge is output, as the output of the source follower circuit, to the vertical signal line VSL via the selection transistor 110.

A light-receiving surface of the first photoelectric conversion element 101 is wider than that of the second photoelectric conversion element 102. That is, in the present embodiment, the first photoelectric conversion element 101 has a large area, and the second photoelectric conversion element 102 has a small area. In that case, in a case where imaging is performed under a condition of the same illuminance and the same exposure time, the charge generated in the first photoelectric conversion element 101 is greater in amount than the charge generated in the second photoelectric conversion element 102. For that reason, a voltage change before and after transferring the charge generated by the first photoelectric conversion element 101 to the FD part 107 is greater than a voltage change before and after transferring the charge generated by the second photoelectric conversion element 102 to the FD part 107. This indicates that when the first photoelectric conversion element 101 and the second photoelectric conversion element 102 are compared with each other, the first photoelectric conversion element 101 has higher sensitivity than the second photoelectric conversion element 102.

On the other hand, in the second photoelectric conversion element 102, even in a case where high illuminance light is incident and charge exceeding the saturated charge amount of the second photoelectric conversion element 102 is generated, the charge generated in excess of the saturated charge amount can be stored in the charge storage part 111, so that when the charge generated in the second photoelectric conversion element 102 is subjected to charge-voltage conversion, the charge-voltage conversion can be performed after adding both the charge stored in the second photoelectric conversion element 102 and the charge stored in the charge storage part 111.

As a result, as compared with the first photoelectric conversion element 101, the second photoelectric conversion element 102 can capture an image having gradation over a wide illuminance range, in other words, can capture an image having a wide dynamic range.

Two images, an image with high sensitivity captured with use of the first photoelectric conversion element 101 and an image with a wide dynamic range captured with use of the second photoelectric conversion element 102, are combined into a single image by being subjected to a wide dynamic range image synthesis processing of synthesizing one image from two images in, for example, an image signal processing circuit provided inside the CMOS image sensor 10, or an image signal processing device externally connected to the CMOS image sensor 10.

1.3 Planar layout of unit pixels

Next, a planar layout of the unit pixel 100 illustrated in Fig. 2 will be described.

1.3.1 Planar layout of second surface

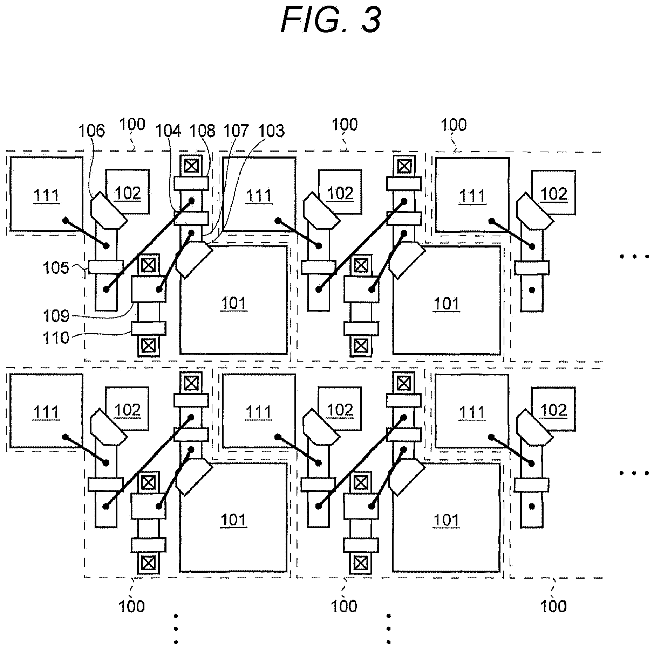

Fig. 3 is a schematic diagram illustrating a planar layout example of the unit pixels according to the present embodiment. Note that, Fig. 3 illustrates a case where the unit pixel 100 is a so-called backside illumination type CMOS image sensor.

In the backside illumination type CMOS image sensor 10, the silicon substrate on which the first photoelectric conversion element 101 and the second photoelectric conversion element 102 are formed includes a first surface that is an incident surface of light to the photodiode, and a second surface facing the first surface. Fig. 3 illustrates a planar layout on the second surface of the silicon substrate related to the unit pixel 100, the planar layout illustrating an active region, the photoelectric conversion elements, the pixel transistors, and the charge storage part provided in the unit pixel 100, and wiring lines connecting these to each other.

As illustrated in Fig. 3, the first photoelectric conversion element 101, the first transfer transistor 103, the FD part 107, the second transfer transistor 104, a part of the node 112, the reset transistor 108, and a connection portion to the power supply VDD are formed on a contiguous first active region.

On the other hand, the second photoelectric conversion element 102, the fourth transfer transistor 106, the node 113, the third transfer transistor 105, and another part of the node 112 are formed on a contiguous second active region different from the first active region.

Furthermore, a connection portion to the vertical signal line VSL, the selection transistor 110, the amplification transistor 109, and a connection portion to the power supply VDD are formed on a contiguous third active region different from the first and second active regions.

Moreover, the charge storage part 111 is formed on a fourth active region (not illustrated) different from the first to third active regions described above. In the fourth active region where an impurity region serving as a lower electrode of the charge storage part 111 is formed, the dielectric film is arranged on the fourth active region, and an upper electrode is further arranged on the dielectric film, so that only the upper electrode is illustrated in Fig. 3. Below the upper electrode, the fourth active region is arranged in which the lower electrode is formed.

In Fig. 3, the FD part 107 and the gate electrode of the amplification transistor 109 are connected together by a wiring line arranged above the gate electrode. Furthermore, the part of the node 112 formed on the first active region and the other part of the node 112 formed on the second active region are also connected together by a wiring line arranged above each gate electrode. Moreover, the node 113 and the upper electrode of the charge storage part 111 are also connected together by a wiring line arranged above each gate electrode and the upper electrode of the charge storage part 111.

Note that, a region surrounded by a dotted line in Fig. 3 corresponds to a region for one unit pixel 100 illustrated in Fig. 2. Thus, the unit pixels 100 are arranged in a two-dimensional lattice, whereby the first photoelectric conversion elements 101 are arranged in a two-dimensional lattice. The second photoelectric conversion elements 102 are arranged between the first photoelectric conversion elements 101, thereby being arranged in a two-dimensional lattice.

1.3.2 Planar layout of first surface and second surface

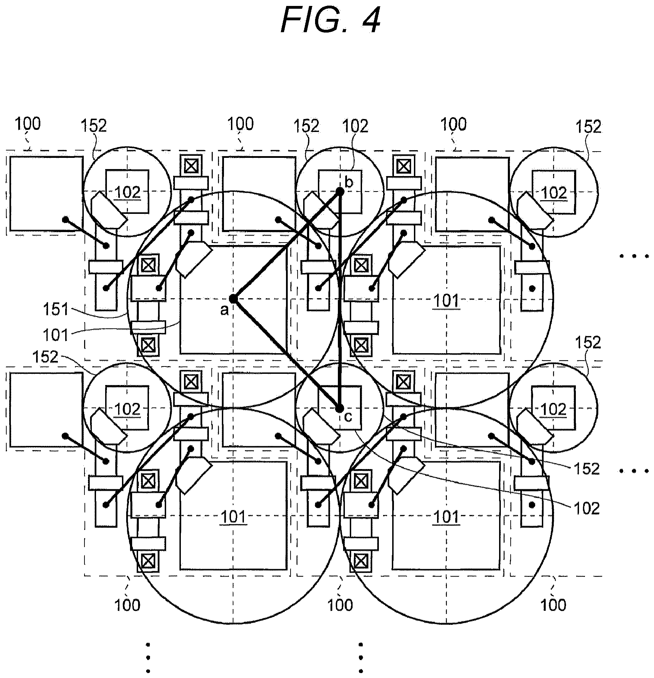

Fig. 4 is a schematic diagram illustrating the planar layout example of the unit pixels according to the present embodiment, and is a schematic diagram in which the planar layout on the second surface of the silicon substrate and a planar layout on the first surface are superimposed on each other. That is, in Fig. 4, in addition to the planar layout of the second surface illustrated in Fig. 3, a planar layout is illustrated of the photoelectric conversion elements and the on-chip lenses formed on the first surface. Note that, a region surrounded by a dotted line in Fig. 4 corresponds to a region for one unit pixel 100 illustrated in Fig. 2.

As illustrated in Fig. 4, the first photoelectric conversion element 101 and the second photoelectric conversion element 102 are each positioned in the same region on the second surface and the first surface.

A first on-chip lens 151 that focuses light incident on the first photoelectric conversion element 101 is arranged to cover the first photoelectric conversion element 101. Similarly, a second on-chip lens 152 that focuses light incident on the second photoelectric conversion element 102 is arranged to cover the second photoelectric conversion element 102.

The size of the first on-chip lens 151 and the second on-chip lens 152 can be set as appropriate depending on factors in pixel design, for example, what range of light is focused and incident on the photoelectric conversion element on the first surface, what size the photoelectric conversion element, pixel transistor, and charge storage part have on the second surface and thus how large the size of one pixel, and the pixel pitch in a case where the pixels are arranged in an array are to be set, or the like.

For example, in a case where the on-chip lens is too large, demerits occur, such as a decrease in the resolution of the imaging device, and generation of a useless region in which the component of the unit pixel is not arranged on the second surface. On the other hand, in a case where the on-chip lens is too small, a demerit occurs such as a decrease in sensitivity due to decreases in light incident on the photoelectric conversion element. For this reason, it is preferable that the size of the on-chip lens on the first surface and the size of each component of the unit pixel on the second surface are appropriately designed while the sensitivity and the resolution are rebalanced.

In Fig. 4, a case is illustrated where, as a result of the pixel design, the diameter of the first on-chip lens 151 is made equal to the pixel pitch and the first on-chip lenses 151 are arranged vertically and horizontally in a two-dimensional lattice, and the diameter of the second on-chip lens 152 is designed so that the second on-chip lens 152 fits in a region of a gap between the first on-chip lenses 151.

In this case, a distance ab from a center a of the first on-chip lens 151 included in a first pixel to a center b of the first on-chip lens 151 included in a second pixel adjacent to the first pixel, a distance ac from the center a of the first on-chip lens 151 included in the first pixel to a center c of the second on-chip lens 152 included in a third pixel, a distance be from the center b of the first on-chip lens 151 included in the second pixel to the center c of the second on-chip lens 152 included in the third pixel, a radius r1 of the first on-chip lens 151 included in each pixel, and a radius r2 of the second on-chip lens 152 included in each pixel have relationships illustrated in the following expressions (1) to (3).

$$\text{Distance ab} = r1 \times 2 \quad \cdots \text{(1)}$$

$$\text{Distance ac} = \text{distance bc} = \text{distance ab} \times \sqrt{2}/2 \quad \cdots \text{(2)}$$

$$r2 \le r1 \times (\sqrt{2} - 1) \quad \cdots \text{(3)}$$

From the expression (1), the distance ab is twice the radius r1 of the first on-chip lens 151, and the distance is equivalent to the diameter of the first on-chip lens 151. Furthermore, from the expression (2), the distance ac and the distance be are the same distance, and have a value obtained by dividing, by two, a value obtained by multiplying the distance ab by the square root of two. That is, the distance ac (distance bc) has a value obtained by multiplying the radius r1 of the first on-chip lens 151 by the square root of two. From the expression (3), the radius r2 of the second on-chip lens 152 can be derived from the expressions (1) and (2), and is less than or equal to a value obtained by multiplying, by the radius r1, a value obtained by subtracting one from the square root of two.

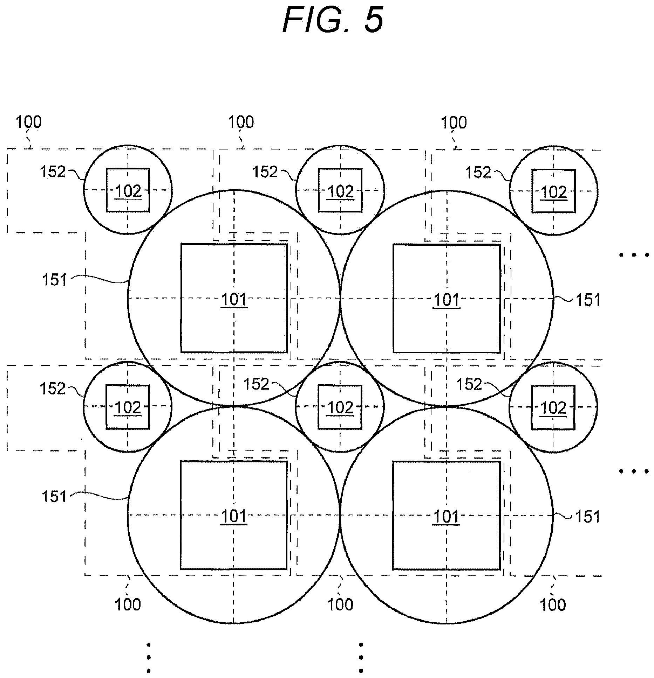

Fig. 5 is a schematic diagram illustrating the planar layout example of the unit pixels according to the present embodiment, and is a diagram in which a planar layout is extracted of the first photoelectric conversion element 101, the second photoelectric conversion element 102, the first on-chip lens 151, and the second on-chip lens 152 on the first surface, from Fig. 4. Note that, a region surrounded by a dotted line in Fig. 5 corresponds to a region for one unit pixel 100 illustrated in Fig. 2.

In Fig. 5, similarly to Fig. 4, a case is illustrated where, as a result of the pixel design, the diameter of the first on-chip lens 151 is made equal to the pixel pitch and the first on-chip lenses 151 are arranged vertically and horizontally in a two-dimensional lattice, and the diameter of the second on-chip lens 152 is designed so that the second on-chip lens 152 fits in a region of a gap between the first on-chip lenses 151.

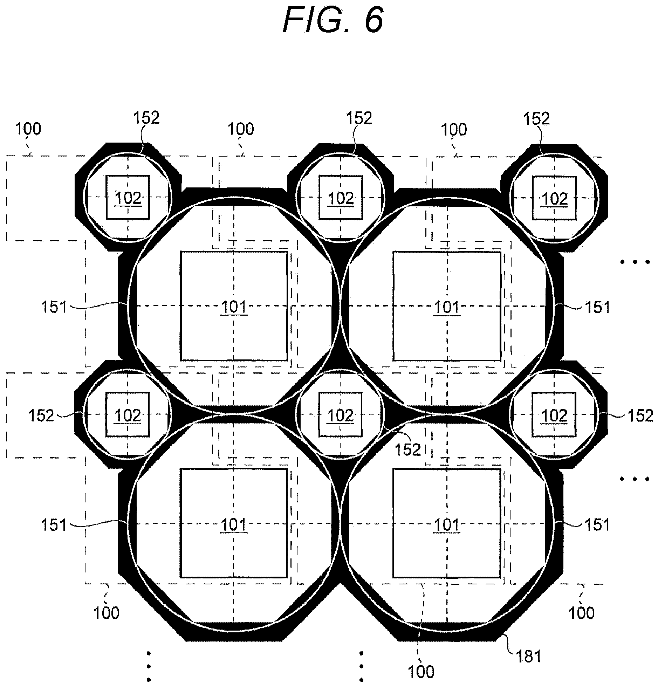

Fig. 6 is a schematic diagram illustrating the planar layout example of the unit pixels according to the present embodiment, and is a diagram in which a planar layout is extracted of an inter-pixel light shielding portion 181 provided between the pixels on the first surface of the unit pixel 100, in addition to the first photoelectric conversion element 101, the second photoelectric conversion element 102, the first on-chip lens 151, and the second on-chip lens 152 on the first surface illustrated in Fig. 5.

As illustrated in Fig. 6, the Inter-pixel light shielding portion 181 is provided to prevent light from leaking to adjacent pixels. In a portion where the first on-chip lens 151 of a certain pixel and the first on-chip lens 151 of a pixel adjacent to the certain pixel are closest to each other, the Inter-pixel light shielding portion 181 is arranged to have the same widths respectively in the inward directions of these two on-chip lenses.

Furthermore, in a portion where the first on-chip lens 151 and the second on-chip lens 152 are closest to each other, the Inter-pixel light shielding portion 181 is arranged to have the same widths in the inward directions of these two on-chip lenses.

1.4 Planar layout of color filters

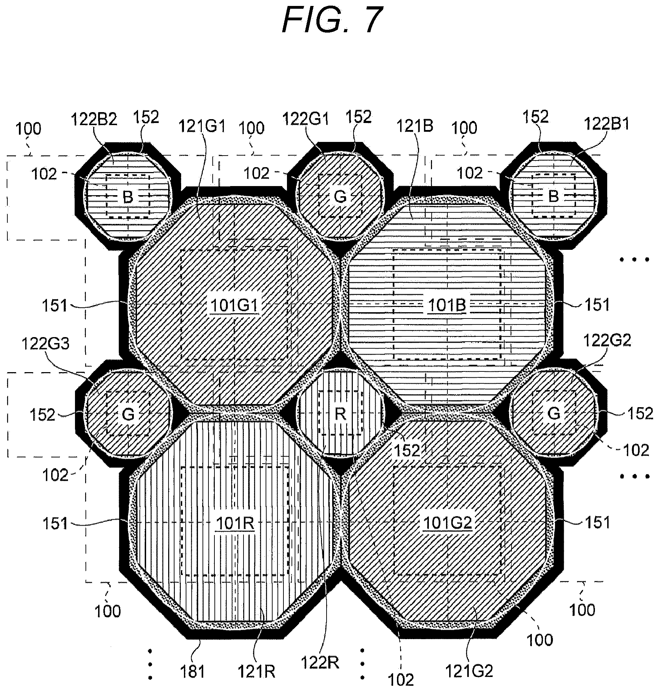

Fig. 7 is a plan view illustrating a planar layout example of a color filter array according to the present embodiment, and is a diagram in which a planar layout is extracted of first color filters 121R, 121G1, 121G2, and 121B, and second color filters 122R, 122G1 to 122G3, 122B1, and 122B2 provided for each pixel on the first surface of the unit pixel 100, in addition to the planar layout of the first photoelectric conversion element 101, the second photoelectric conversion element 102, the first on-chip lens 151, the second on-chip lens 152, and the inter-pixel light shielding portion 181 on the first surface illustrated in Fig. 6. Note that, in the following description, in a case where the first color filters are not distinguished from each other, a reference numeral 121 is used. Similarly, in a case where the second color filters are not distinguished from each other, a reference numeral 122 is used.

The first color filter 121 is a color filter provided for the first photoelectric conversion element 101 constituting a large pixel, and, for example, is arranged between the first on-chip lens 151 and the first photoelectric conversion element 101 in each pixel.

The second color filter 122 is a color filter provided for the second photoelectric conversion element 102 constituting a small pixel, and, for example, is arranged between the second on-chip lens and the second photoelectric conversion element 102 in each pixel.

1.4.1 Planar layout of color filters for large pixels

As illustrated in Fig. 7, the first color filter 121 for the large pixel is arranged on the first surface in accordance with the rules of the Bayer array, for example. Thus, in a total of four large pixels of 2 × 2 pixels that are a unit of repetition of the Bayer array, two first color filters 121G1 and 121G2 that transmit a wavelength component of green (G) are positioned diagonally, and the first color filter 121B that transmits a wavelength component of blue (B) and the first color filter 121R that transmits a wavelength component of red (R) are arranged diagonally so as to intersect with the two first color filters 121G1 and 121G2.

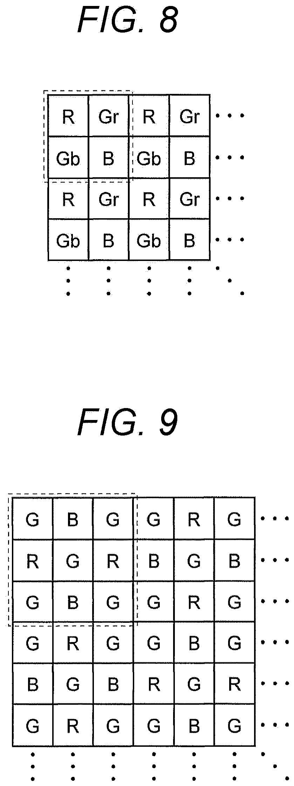

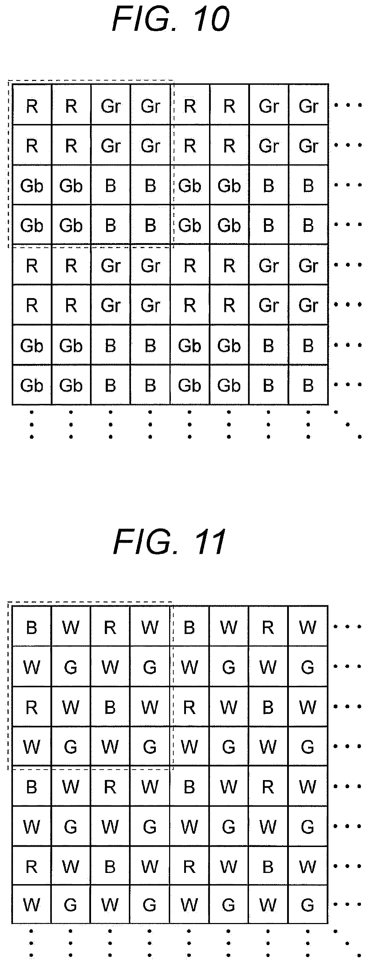

However, the arrangement of the first color filter 121 is not limited to the Bayer array whose unit of repetition includes a total of four pixels of 2 × 2 pixels, as illustrated in Fig. 8. It is possible to apply various color filter arrays, for example, an X-Trans (registered trademark) type color filter array whose unit of repetition includes a total of nine pixels of 3 × 3 pixels as illustrated in Fig. 9, a quad Bayer array whose unit of repetition includes a total of 16 pixels of 4 × 4 pixels as illustrated in Fig. 10, a white RGB type color filter array that includes a color filter having a broad light transmission characteristic for visible light and whose unit of repetition includes a total of 16 pixels of 4 × 4 pixels as illustrated in Fig. 11, and the like.

Note that, in Figs. 8 to 11, 'R' indicates a color filter that transmits the wavelength component of red (R); 'G', 'Gr', and 'Gb' each indicate a color filter that transmits the wavelength component of green (G); and 'B' indicates a color filter that transmits the wavelength component of blue (B). Furthermore, 'W' indicates a color filter having a broad light transmission characteristic for visible light.

Furthermore, in Figs. 8 to 11, a region surrounded by a broken line is a pattern that is a unit of repetition in each color filter array.

1.4.2 Planar layout of color filters for small pixels

In the present embodiment, similarly to the first color filter 121 provided for the large pixel, the second color filter 122 provided for the small pixel is basically includes a combination of color filters that transmit the same wavelength components as those of the color filter arrays such as the Bayer array, X-Trans (registered trademark) type array, quad Bayer array, and white RGB array. For example, in a case where the Bayer array is applied to the second color filter 122, the unit of repetition of the array includes two second color filters 122G1 and 122G2 that transmit the wavelength component of green (G), one second color filter 122R that transmits the wavelength component of red (R), and one second color filter 122B that transmits the wavelength component of blue (B).

However, in the present embodiment, the arrangement of the second color filter 122 is not limited to a specific color filter array such as the Bayer array, X-Trans (registered trademark) type array, quad Bayer array, and white RGB array. That is, in the present embodiment, as will be described later, a wavelength component is selected as appropriate that is transmitted by the second color filter 122 provided for a small pixel that is an outflow destination of a leakage current leaked from each large pixel, depending on ease of saturation of each large pixel.

1.4.2.1 Outflow destination of leakage current from large pixel

Here, a description will be given of the outflow destination of charge leaked from the first photoelectric conversion element 101 that is a large pixel. As described above, since the first photoelectric conversion element 101 has a large area and the second photoelectric conversion element 102 has a small area, the first photoelectric conversion element 101 has higher sensitivity than the second photoelectric conversion element 102. For that reason, in the first photoelectric conversion element 101 and the second photoelectric conversion element 102, the first photoelectric conversion element 101 is saturated first.

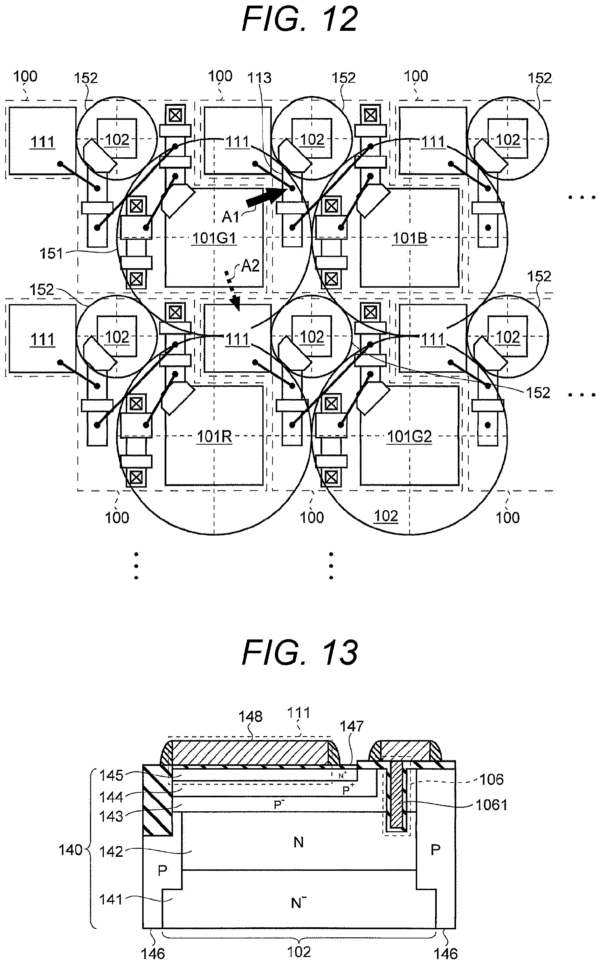

Thus, for example, in a case where the color filter array of the first color filter 121 for the large pixel is the Bayer array, as illustrated in Fig. 12, in the first photoelectric conversion element 101 provided with the first color filter 121R that transmits the wavelength component of red (R) (the reference numeral of this first photoelectric conversion element 101 is 101R), the first photoelectric conversion elements 101 provided with the first color filters 121G1 and 121G2 that transmit the wavelength component of green (G) (the reference numerals of these first photoelectric conversion elements 101 are 101G1 and 101G2), and the first photoelectric conversion element 101 provided with the first color filter 121B that transmits the wavelength component of blue (B) (the reference numeral of this first photoelectric conversion element 101 is 101B), the first photoelectric conversion elements 101G1 and 101G2 provided with the first color filters 121G1 and 121G2 that transmit the wavelength component of green (G) have the highest sensitivity.

That is, the first photoelectric conversion elements 101G1 and 101G2 have the largest amount of charge generated per unit time, for example, in a case where white light having a broad light intensity in the visible light region is incident on the first photoelectric conversion elements 101R, 101G1, 101G2, and 101B.

This means that among the first photoelectric conversion elements 101R, 101G1, 101G2, and 101B, the first photoelectric conversion elements 101G1 and 101G2 are most likely to cause blooming, saturated the earliest, and likely to become a generation source of a leakage current.

The leakage current leaked from the first photoelectric conversion element 101 flows into a small pixel adjacent to the charge storage region in a relative largest amount among four small pixels adjacent to the first photoelectric conversion element 101.

Here, in the present embodiment, the charge storage region of the large pixel corresponds to the first photoelectric conversion element 101, and the charge storage region of the small pixel corresponds to a configuration including the second photoelectric conversion element 102, the charge storage part 111, and the node 113 connecting these together. Note that, the charge storage part 111 is, for example, CI capacitance using an insulating film, and as illustrated in Fig. 13, has structure in which a polysilicon electrode 148 formed on a silicon substrate 140 that is a semiconductor substrate is a layer (charge storage layer) that stores charge.

Note that, in Fig. 13, an N+ diffusion region 145 formed on an upper layer on the surface side of the silicon substrate 140 functions as another electrode of the charge storage part 111. A silicon oxide film 147 that is a dielectric is formed between the N+ diffusion region 145 and the polysilicon electrode 148.

Furthermore, an N diffusion region 142 and an N- diffusion region 141 surrounded by a P- diffusion region 143 and a P diffusion region 146 form, for example, the second photoelectric conversion element 102. The charge storage part 111 and the second photoelectric conversion element 102 are electrically isolated from each other by a P+ diffusion region 144. Moreover, in the N diffusion region 142 of the second photoelectric conversion element 102, a gate electrode 1061 of the fourth transfer transistor 106 is formed that reaches from the upper surface side of the silicon substrate 140 to the N diffusion region 142.

In the example illustrated in Fig. 12, a charge storage region of a small pixel closest to the first photoelectric conversion element 101G1 in the upper left of the drawing includes the node 113 positioned at the upper right with respect to the first photoelectric conversion element 101G1. Thus, the leakage current leaked from the first photoelectric conversion element 101G1 flows into the small pixel positioned at the upper right with respect to the first photoelectric conversion element 101G1 in the largest amount via the node 113, as illustrated by an arrow A1 in Fig. 12.

Note that, for example, the leakage current leaked from the first photoelectric conversion element 101G1 also flows into the small pixel including the charge storage part 111 positioned at the lower right with respect to the first photoelectric conversion element 101G1 as illustrated by an arrow A2 in Fig. 12, but most of the leakage current flows (arrow A1) into the small pixels positioned at the upper right with respect to the first photoelectric conversion element 101G1, so that the amount of current (arrow A2) flowing into the small pixel positioned at the lower right is relatively small.

Furthermore, since pixel transistors respectively exist between the small pixel at the upper left of Fig. 12 and the first photoelectric conversion element 101G1 and between the small pixel at the lower left of Fig. 12 and the first photoelectric conversion element 101G1, inflow of the leakage current from the first photoelectric conversion element 101G1 to the upper left small pixel and inflow of the leakage current from the first photoelectric conversion element 101G1 to the lower left small pixel are negligibly small.

The above description is similar for the other first photoelectric conversion elements 101R, 101G2, and 101B. Note that, in this description, for the sake of clarification, a small pixel into which the leakage current leaked from the large pixel flows in the largest amount is referred to as a "small pixel that is an outflow destination of the leakage current from the large pixel".

1.4.2.2 Combination of large pixel and small pixel

Thus, in the present embodiment, as the second color filter 122 of the small pixel (in this example, the small pixel positioned at the upper right of the large pixel) that is an outflow destination of the leakage current from the large pixel, the second color filter 122 is used that transmits the same wavelength component as that of the first color filter 121 of the large pixel. That is, a color filter that transmits the same wavelength component is provided for the large pixel and the small pixel that is the outflow destination of the leakage current from the large pixel.

For example, in the examples illustrated in Figs. 7 and 12, as illustrated in Fig. 12, for the second photoelectric conversion element 102 of the small pixel that is the outflow destination of the leakage current of the first photoelectric conversion element 101G1 or 101G2 provided with the first color filter 121G1 or 121G2 that transmits the wavelength component of green (G), the second color filter 122G1 or 122G2 that similarly transmits the wavelength component of green (G) is provided as illustrated in Fig. 7.

Similarly, as illustrated in Fig. 12, for the second photoelectric conversion element 102 of the small pixel that is the outflow destination of the leakage current of the first photoelectric conversion element 101R provided with the first color filter 121R that transmits the wavelength component of red (R), the second color filter 122R that similarly transmits the wavelength component of red (R) is provided as illustrated in Fig. 7, and as illustrated in Fig. 12, for the second photoelectric conversion element 102 of the small pixel that is the outflow destination of the leakage current of the first photoelectric conversion element 101B provided with the first color filter 121B that transmits the wavelength component of blue (B), the second color filter 122B that similarly transmits the wavelength component of blue (B) is provided as illustrated in Fig. 7.

1.5 Function and effect

As described above, according to the present embodiment, the second photoelectric conversion element 102 of the small pixel that is the outflow destination of the leakage current from the large pixel is provided with the second color filter 122 that transmits the same wavelength component as that of the first color filter 121 provided for the first photoelectric conversion element 101 of the large pixel. Therefore, the leakage current leaked from the large pixel flows into the small pixel that generates charge on the basis of light having the same wavelength component as the large pixel, so that it is possible to reduce inflow of charge generated by light having a different wavelength component into the small pixel. As a result, influence of the leakage current on the small pixel is reduced, so that a noise ratio (S/N ratio) in image data read from the small pixel can be improved.

Note that, in the above description, a case has been exemplified where color filters that selectively transmit the wavelength components of the RGB three primary colors are adopted for the first color filter 121 and the second color filter 122; however, this is not a limitation, and it is also possible to adopt color filters that selectively transmit the wavelength components of colors having a complementary color relationship with the RGB three primary colors.

## 2. Second embodiment

Next, a second embodiment will be described in detail with reference to the drawings. In the first embodiment described above, a case has been described where there is one small pixel that is the outflow destination of the leakage current from the large pixel. However, there is not always only one small pixel that is the outflow destination of the leakage current from the large pixel.

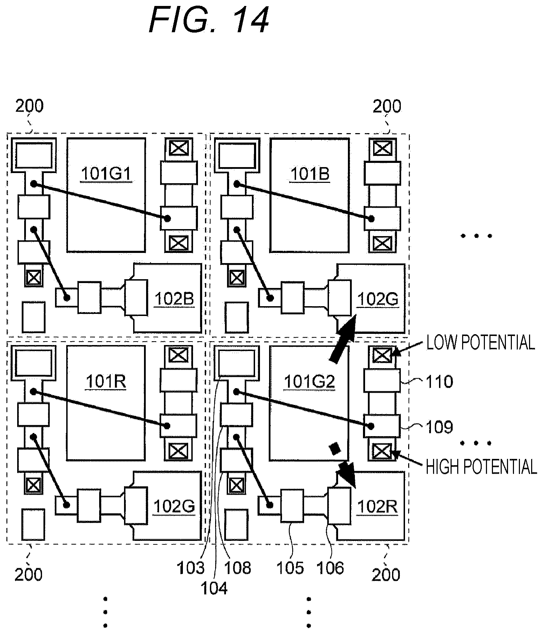

For example, as in an arrangement of unit pixels 200 illustrated in Fig. 14, there may also be a case where there are two or more second photoelectric conversion elements 102 (two in Fig. 14) that are closest to the first photoelectric conversion element 101.

In such a case, a larger amount of the leakage current leaked from the first photoelectric conversion element 101 flows into the second photoelectric conversion element 102 in which a pixel transistor charged at the lowest potential exists in the vicinity, among the second photoelectric conversion elements 102 that are candidates for the outflow destination.

This is because the outflow destination of the leakage current leaked from the first photoelectric conversion element 101 overcoming the potential barrier is a high potential region.

For example, in the example illustrated in Fig. 14, as the charge storage region of the small pixel closest to the first photoelectric conversion element 101G2 at the lower right in the drawing, there are two second photoelectric conversion elements, the second photoelectric conversion element 102G positioned at the upper right with respect to the first photoelectric conversion element 101G2, and the second photoelectric conversion element 102R existing in the lower right.

Here, the pixel transistor close to the second photoelectric conversion element 102G on the upper right is the selection transistor 110, and the pixel transistor close to the second photoelectric conversion element 102R on the lower right is the amplification transistor 109.

During the storage period, the power supply voltage VDD is applied to the drain of the amplification transistor 109. Thus, a drain voltage of the amplification transistor 109 is a high potential. On the other hand, during the storage period, a source voltage of the selection transistor 110 is a low potential at a clip voltage.

Thus, for example, when it is assumed that the amount of leakage current flowing out to the amplification transistor 109 side (hereinafter referred to as a high potential side) and the amount of leakage current flowing out to the selection transistor 110 side (hereinafter referred to as a low potential side) are the same as each other, most of the leakage current flowing out to the high potential side flows into the drain of the amplification transistor 109, whereby the leakage current flowing into the second photoelectric conversion element 102R existing in the vicinity of the amplification transistor 109 is relatively small.

On the other hand, of the leakage current flowing out to the low potential side, the amount flowing into the source of the selection transistor 110 is smaller than the amount of leakage current flowing into the drain of the amplification transistor 109. For that reason, the amount of leakage current flowing into the second photoelectric conversion element 102G existing in the vicinity of the selection transistor 110 is eventually larger than the amount of leakage current flowing into the second photoelectric conversion element 102R existing in the vicinity of the amplification transistor 109.

Thus, in the present embodiment, as the second color filter 122 arranged on the second photoelectric conversion element 102G close to the selection transistor 110 on the low potential side, the second color filter 122G is used that transmits the wavelength component of green (G) that is the same as the first color filter 121G arranged on the first photoelectric conversion element 101G.

Furthermore, similarly for the other small pixels, as the second color filter 122 arranged on the second photoelectric conversion element 102 close to the selection transistor 110 on the low potential side, the second color filter 122 is used that transmits the same wavelength component as that of the first color filter 121 arranged on the first photoelectric conversion element 101 that is the generation source of the leakage current.

Note that, in the present embodiment, the charge storage region of the large pixel corresponds to the first photoelectric conversion element 101, and the charge storage region of the small pixel corresponds to the second photoelectric conversion element 102.

## 2.1 Function and effect

As described above, according to the present embodiment, in a case where there are two or more small pixels that are the outflow destinations of the leakage current from the large pixel, a small pixel close to a pixel transistor having the lowest potential among pixel transistors close to outflow destination candidates is provided with the second color filter 122 that transmits the same wavelength component as that of the first color filter 121 of the large pixel that is the generation source of the leakage current. As a result, similarly to the first embodiment, the leakage current leaked from the large pixel flows into the small pixel that generates charge on the basis of light having the same wavelength component as the large pixel, so that it is possible to reduce inflow of charge generated by light having a different wavelength component into the small pixel. As a result, influence of the leakage current on the small pixel is reduced, so that a noise ratio (S/N ratio) in image data read from the small pixel can be improved.

Since other configurations, operations, and effects may be similar to those in the above-described embodiment, detailed description thereof will be omitted here.

3. Third embodiment

Furthermore, in the second embodiment, a case has been described where there are two or more small pixels that are the outflow destinations of the leakage current from the large pixel; however, conversely, there may also be a case where there is no small pixel that is the outflow destination of the leakage current from the large pixel.

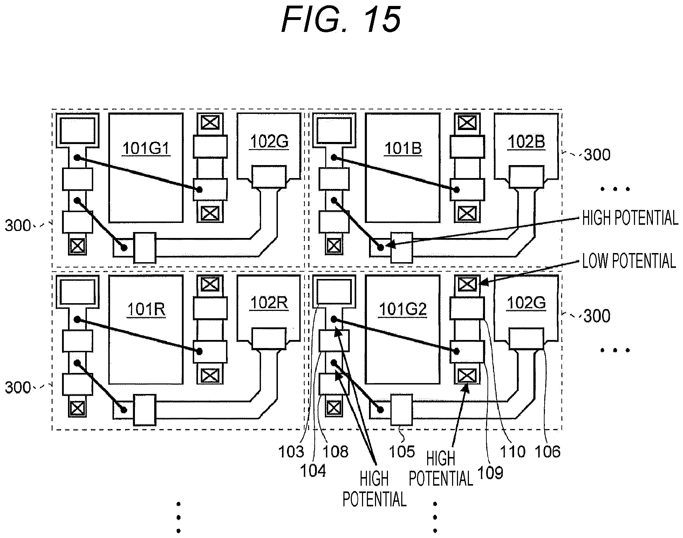

For example, as in an arrangement of unit pixels 300 illustrated in Fig. 15, in a layout in which the first photoelectric conversion element 101 is surrounded by pixel transistors, there are no small pixels adjacent to the first photoelectric conversion element 101. In this case, there is no candidate for the small pixel that is the outflow destination of the leakage current from the large pixel.

Even in such a case, similarly to the second embodiment, as the second color filter 122 of the small pixel positioned in the vicinity of a pixel transistor having the lowest potential during the storage period among peripheral pixel transistors, the second color filter 122 is used that transmits the same wavelength component as that of the first color filter 121 of the large pixel.

For example, in the example illustrated in Fig. 15, as the second color filter 122 arranged on the second photoelectric conversion element 102G positioned in the vicinity of the selection transistor 110 having the lowest potential at the clip voltage, among the first transfer transistor 103, the second transfer transistor 104, the third transfer transistor 105, the reset transistor 108, the amplification transistor 109, and the selection transistor 110 surrounding the first photoelectric conversion element 101G2 that is a large pixel, the second color filter 122G is used that transmits the same wavelength component as the first color filter 121G2 arranged on the first photoelectric conversion element 101G2.

Note that, in the present embodiment, the charge storage region of the large pixel corresponds to the first photoelectric conversion element 101, and the charge storage region of the small pixel corresponds to the second photoelectric conversion element 102.

3.1 Function and effect

As described above, according to the present embodiment, in a case where there is no small pixel that is the outflow destination of the leakage current from the large pixel, a small pixel close to a pixel transistor having the lowest potential among pixel transistors arranged in the periphery of the large pixel is provided with the second color filter 122 that transmits the same wavelength component as that of the first color filter 121 of the large pixel that is the generation source of the leakage current. As a result, similarly to the above-described embodiments, the leakage current leaked from the large pixel flows into the small pixel that generates charge on the basis of light having the same wavelength component as the large pixel, so that it is possible to reduce inflow of charge generated by light having a different wavelength component into the small pixel. As a result, influence of the leakage current on the small pixel is reduced, so that a noise ratio (S/N ratio) in image data read from the small pixel can be improved.

Since other configurations, operations, and effects may be similar to those in the above-described embodiment, detailed description thereof will be omitted here.

4. Fourth embodiment

In the above-described embodiments, a case has been described where elements constituting the unit of repetition of the first color filter 121 provided for the large pixel and elements constituting the unit of repetition of the second color filter 122 provided for the small pixel are the same as each other. A case has been described where, for example, in a case where the Bayer array is adopted as the color filter array, as the elements constituting the unit of repetition of the first color filter 121 provided for the large pixel, one first color filter 121R that transmits the wavelength component of red (R), two first color filters 121G that transmit the wavelength component of green (G), and one first color filter 121B that transmits the wavelength component of blue (B) are included, and similarly, as the elements constituting the unit of repetition of the second color filter 122 provided for the small pixel, one second color filter 122R that transmits the wavelength component of red (R), two second color filter 122G that transmit the wavelength component of green (G), and one second color filter 122B that transmits the wavelength component of blue (B) are included.

However, the elements constituting the unit of repetition of the first color filter 121 provided for the large pixel and the elements constituting the unit of repetition of the second color filter 122 provided for the small pixel do not necessarily have to coincide with each other That is, the elements constituting the unit of repetition of the first color filter 121 provided for the large pixel and the elements constituting the unit of repetition of the second color filter 122 provided for the small pixel can be independently selected as appropriate.

However, in such a case, there is a case where the second color filter 122 of the small pixel that is the outflow destination of the leakage current from the large pixel is not the second color filter 122 that transmits the same wavelength component as that of the first color filter 121 of the large pixel.

Thus, in the present embodiment, the large pixel and the small pixel are combined in descending order of sensitivity such that a small pixel having the highest sensitivity among small pixels is selected for a small pixel that is the outflow destination of the leakage current from a large pixel having the highest sensitivity, in other words, being saturated the fastest and likely to cause blooming, among large pixels, and a small pixel having the highest sensitivity among the remaining small pixels is selected for a large pixel having the second highest sensitivity, and so on.

As a result, influence of the leakage current on the small pixel can be minimized, so that a noise ratio (S/N ratio) in the image data read from the small pixel can be improved.

4.1 Example of color filter array

The color filter array applied to the large pixel and the color filter array applied to the small pixel will be described below with examples. Note that, in the following description, as the planar layout of the unit pixels, the planar layout described with reference to Figs. 3 to 6 in the first embodiment is referred to; however, this is not a limitation, and it is possible to make various modifications, for example, the planar layout of the unit pixels described with reference to Fig. 14 in the second embodiment, the planar layout of the unit pixels described with reference to Fig. 15 in the third embodiment, and the like.

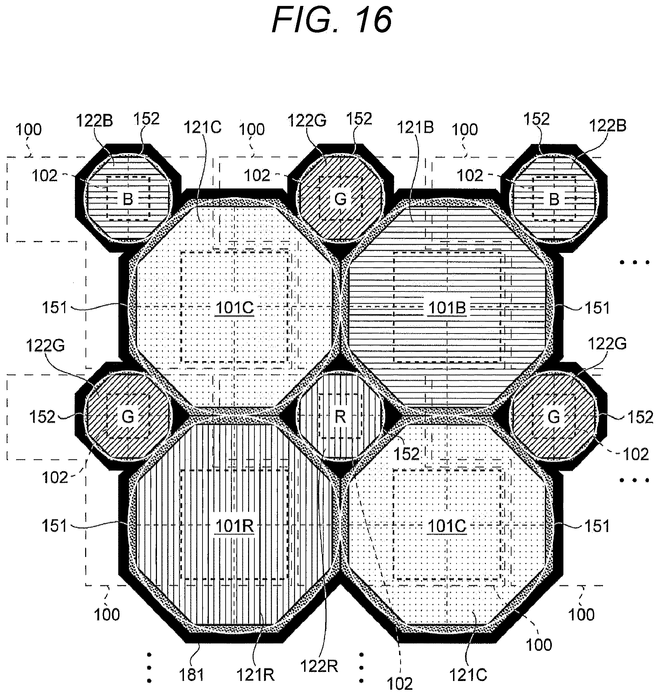

Fig. 16 is a diagram illustrating a planar layout example of the unit pixels according to the present embodiment. However, in Fig. 16, in addition to the planar layout of the first photoelectric conversion element 101, the second photoelectric conversion element 102, the first on-chip lens 151, the second on-chip lens 152, and the Inter-pixel light shielding portion 181 on the first surface, a planar layout is also illustrated of the first color filter 121 and the second color filter 122 provided on each pixel on the first surface of the unit pixel 100.

As illustrated in Fig. 16, in a first example, the elements constituting the unit of repetition of large pixels are a combination of red, clear (white), clear (white), and blue (RCCB), and the elements constituting the unit of repetition of small pixels are a combination of red, green, green, and blue (RGGB) in the Bayer array. Note that, clear (C) is also referred to as white (W), and is a pixel on which a color filter having a broad light transmission characteristic for visible light is arranged.

The sensitivity of a pixel of clear (C) is higher than that of a pixel of green (G), for example. Thus, in the first example, for a small pixel that is the outflow destination of the leakage current from a first photoelectric conversion element 101C that is a large pixel on which a first color filter 121C of clear (C) having the highest sensitivity is arranged, a small pixel is assigned including a second photoelectric conversion element 102G provided with the second color filter 122G that transmits the wavelength component of green (G) and having the highest sensitivity among small pixels.

Note that, for a small pixel that is the outflow destination of the leakage current from the first photoelectric conversion element 101R that is a large pixel on which the first color filter 121R that transmits the wavelength component of red (R) is arranged, a small pixel may be assigned including the second photoelectric conversion element 102R provided with the second color filter 122R that similarly transmits the wavelength component of red (R). Similarly, for a small pixel that is the outflow destination of the leakage current from the first photoelectric conversion element 101B that is a large pixel on which the first color filter 121B that transmits the wavelength component of blue (B) is arranged, a small pixel may be assigned including the second photoelectric conversion element 102B provided with the second color filter 122B that transmits the wavelength component of blue (B).

4.2 Function and effect

As described above, according to the present embodiment, the large pixel and the small pixel are combined in descending order of sensitivity such that a small pixel having the highest sensitivity among small pixels is arranged for a small pixel that is the outflow destination of the leakage current from a large pixel having the highest sensitivity among large pixels, and a small pixel having the highest sensitivity among the remaining small pixels is selected for a large pixel having the second highest sensitivity, and so on. As a result, influence of the leakage current on the small pixel can be minimized, so that a noise ratio (S/N ratio) in the image data read from the small pixel can be improved.

Note that, in the present embodiment, a case has been exemplified where the elements constituting the unit of repetition of the first color filter 121 provided for the large pixel and the elements constituting the unit of repetition of the second color filter 122 provided for the small pixel are different from each other; however, this is not a limitation, and the present embodiment can also be applied to a case where the elements constituting the unit of repetition of the first color filter 121 provided for the large pixel and the elements constituting the unit of repetition of the second color filter 122 provided for the small pixel coincide with each other.

Since other configurations, operations, and effects may be similar to those in the above-described embodiment, detailed description thereof will be omitted here.

5. Fifth embodiment

In the first to third embodiments described above, a case has been exemplified where the color filter array set for the large pixel and the small pixel is the Bayer array of RGGB; however, in the present embodiment, some examples will be described for cases where other color filter arrays are applied.

Note that, in the following description, as the planar layout of the unit pixels, the planar layout described with reference to Figs. 3 to 6 in the first embodiment is referred to; however, this is not a limitation, and it is possible to make various modifications, for example, the planar layout of the unit pixels described with reference to Fig. 14 in the second embodiment, the planar layout of the unit pixels described with reference to Fig. 15 in the third embodiment, and the like.

Furthermore, in each drawing used in the following description, similarly to Fig. 16, in addition to the planar layout of the first photoelectric conversion element 101, the second photoelectric conversion element 102, the first on-chip lens 151, the second on-chip lens 152, and the Inter-pixel light shielding portion 181 on the first surface, a planar layout is also illustrated of the first color filter 121 and the second color filter 122 provided on each pixel on the first surface of the unit pixel 100.

5.1 First example

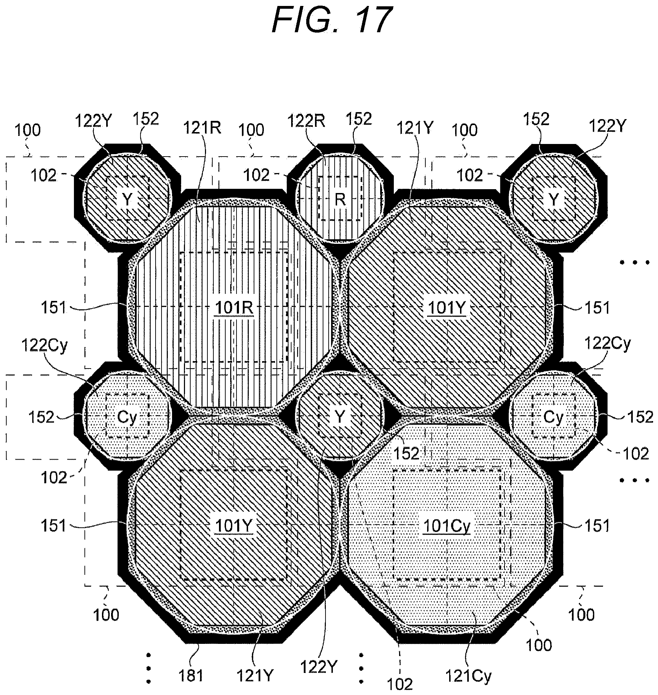

Fig. 17 is a diagram illustrating a planar layout example of unit pixels according to a first example of the present embodiment. As illustrated in Fig. 17, in the first example, to each of large pixels and small pixels, a color filter array is applied that is a combination of a total of four pixels of $2 \times 2$ pixels in which the elements constituting the unit of repetition are red, yellow, yellow, and cyan (RYYCy).

Note that, in Fig. 17, the first color filter 121R is a color filter that transmits the wavelength component of red (R), a first color filter 121Y is a color filter that transmits a wavelength component of yellow (Y), and a first color filter 121Cy is a color filter that transmits a wavelength component of cyan (Cy) that has a complementary color relationship with the RGB three primary colors. Similarly, the second color filter 122R is a color filter that transmits the wavelength component of red (R), a second color filter 122Y is a color filter that transmits the wavelength component of yellow (Y), and a second color filter 122Cy is a color filter that transmits the wavelength component of cyan (Cy).

Furthermore, the first photoelectric conversion element 101R is a photoelectric conversion element that photoelectrically converts light of the wavelength component of red (R) transmitted through the first color filter 121R, a first photoelectric conversion element 101Y is a photoelectric conversion element that photoelectrically converts light of the wavelength component of yellow (Y) transmitted through the first color filter 121Y, and a first photoelectric conversion element 101Cy is a photoelectric conversion element that photoelectrically converts light of the wavelength component of cyan (Cy) transmitted through the first color filter 121Cy. Similarly, the second photoelectric conversion element 102R is a photoelectric conversion element that photoelectrically converts light of the wavelength component of red (R) transmitted through the second color filter 122R, a second photoelectric conversion element 102Y is a photoelectric conversion element that photoelectrically converts light of the wavelength component of yellow (Y) transmitted through the second color filter 122Y, and a second photoelectric conversion element 102Cy is a photoelectric conversion element that photoelectrically converts light of the wavelength component of cyan (Cy) transmitted through the second color filter 122Cy.

5.2 Second example

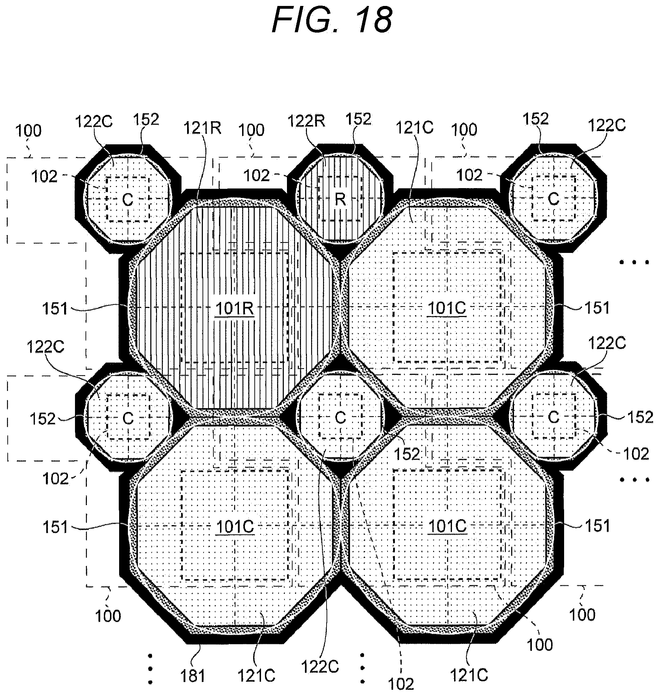

Fig. 18 is a diagram illustrating a planar layout example of unit pixels according to a second example of the present embodiment. As illustrated in Fig. 18, in the second example, to each of large pixels and small pixels, a color filter array is applied that is a combination of a total of four pixels of $2 \times 2$ pixels in which the elements constituting the unit of repetition are red, cyan, cyan, and cyan (RCCC).

5.3 Third example

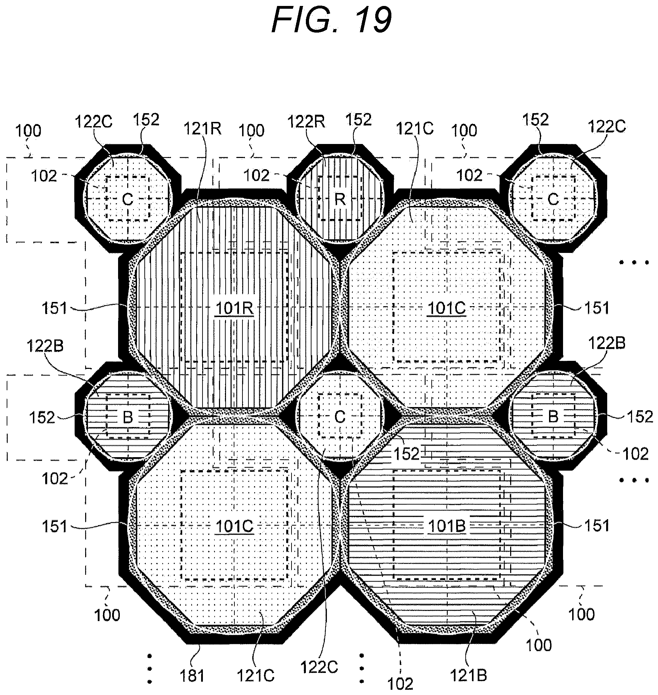

Fig. 19 is a diagram illustrating a planar layout example of unit pixels according to a third example of the present embodiment. As illustrated in Fig. 19, in the third example, to each of large pixels and small pixels, a color filter array is applied that is a combination of a total of four pixels of $2 \times 2$ pixels in which the elements constituting the unit of repetition are red, clear, clear, and blue (RCCB).

5.4 Fourth example

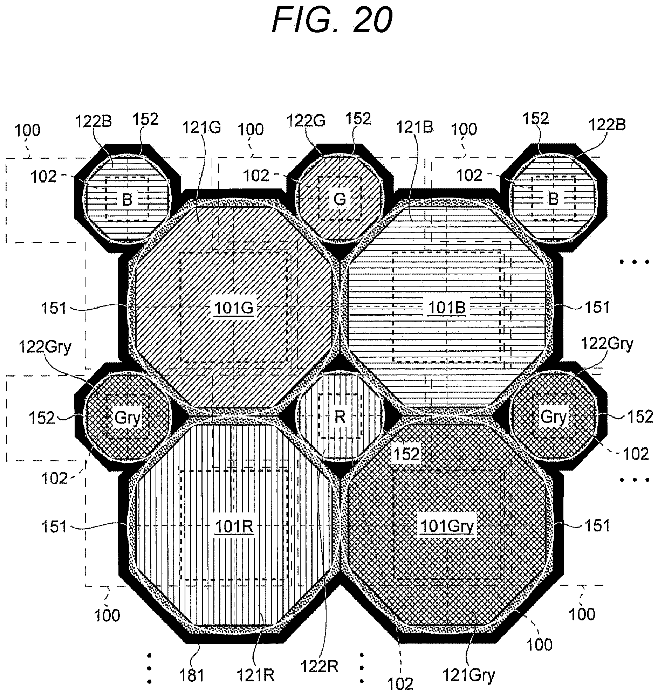

Fig. 20 is a diagram illustrating a planar layout example of unit pixels according to a fourth example of the present embodiment. As illustrated in Fig. 20, in the fourth example, to each of large pixels and small pixels, a color filter array is applied that is a combination of a total of four pixels of $2 \times 2$ pixels in which the elements constituting the unit of repetition are red, green, blue, and gray (RGBGry).

Note that, in Fig. 20, a first color filter 121Gry and a second color filter 122Gry have broad light transmission characteristics for visible light, but are color filters having lower light transmission characteristics (for example, light transmission characteristics that transmit less than or equal to 80% of visible light) than that of the color filter of clear (C). Furthermore, a first photoelectric conversion element 101Gry is a photoelectric conversion element that photoelectrically converts light transmitted through the first color filter 121Gry, and a second photoelectric conversion element 102Gry is a photoelectric conversion element that photoelectrically converts light transmitted through the second color filter 122Gry.

5.5 Fifth example

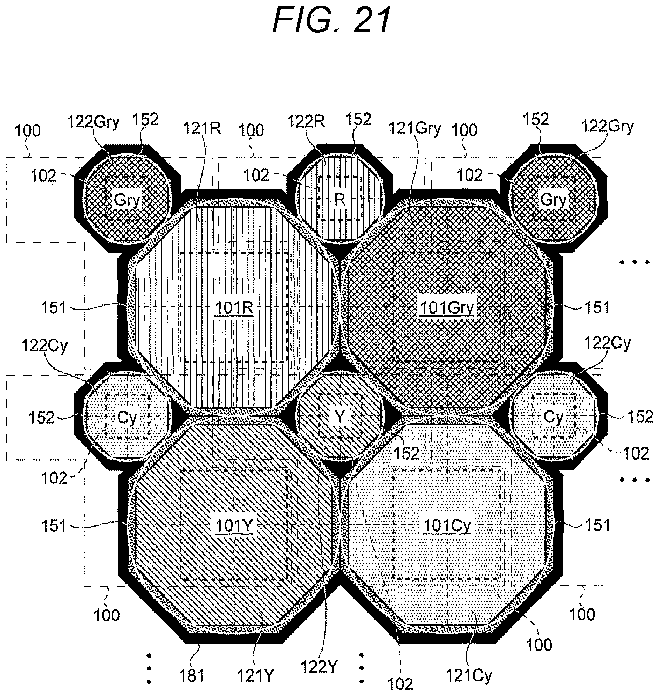

Fig. 21 is a diagram illustrating a planar layout example of unit pixels according to a fifth example of the present embodiment. As illustrated in Fig. 21, in the fifth example, to each of large pixels and small pixels, a color filter array is applied that is a combination of a total of four pixels of $2 \times 2$ pixels in which the elements constituting the unit of repetition are red, gray, yellow, and cyan (RGryYCy).

5.6 Sixth example

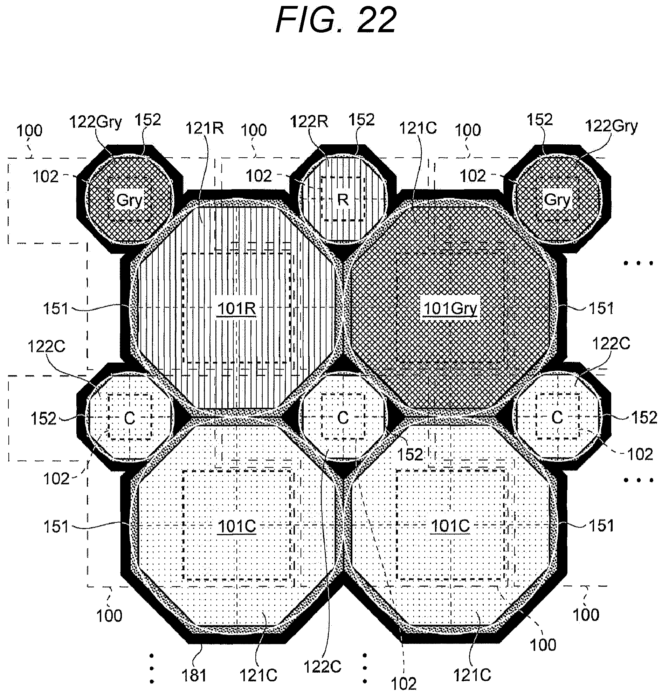

Fig. 22 is a diagram illustrating a planar layout example of unit pixels according to a sixth example of the present embodiment. As illustrated in Fig. 22, in the sixth example, to each of large pixels and small pixels, a color filter array is applied that is a combination of a total of four pixels of $2 \times 2$ pixels in which the elements constituting the unit of repetition are red, gray, clear, and clear (RGryCC).

5.7 Seventh example

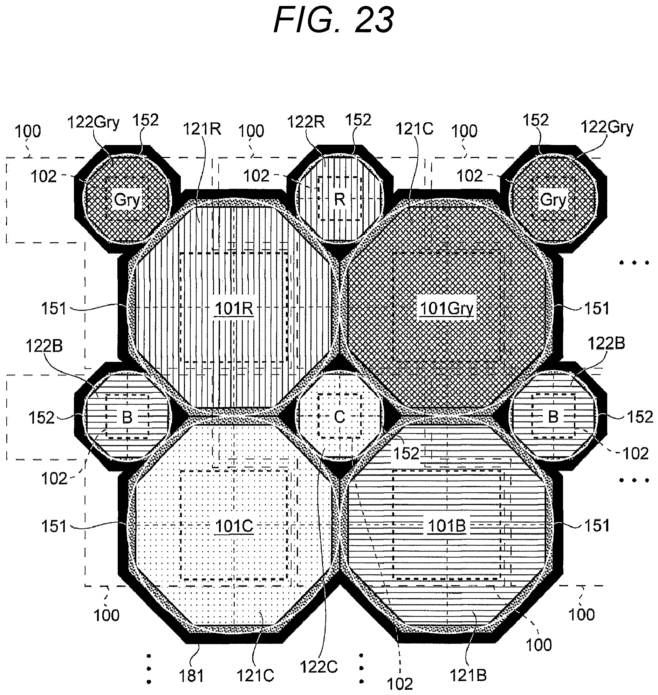

Fig. 23 is a diagram illustrating a planar layout example of unit pixels according to a seventh example of the present embodiment. As illustrated in Fig. 23, in the seventh example, to each of large pixels and small pixels, a color filter array is applied that is a combination of a total of four pixels of $2 \times 2$ pixels in which the elements constituting the unit of repetition are red, gray, clear, and blue (RGryCB).

5.8 Eighth example

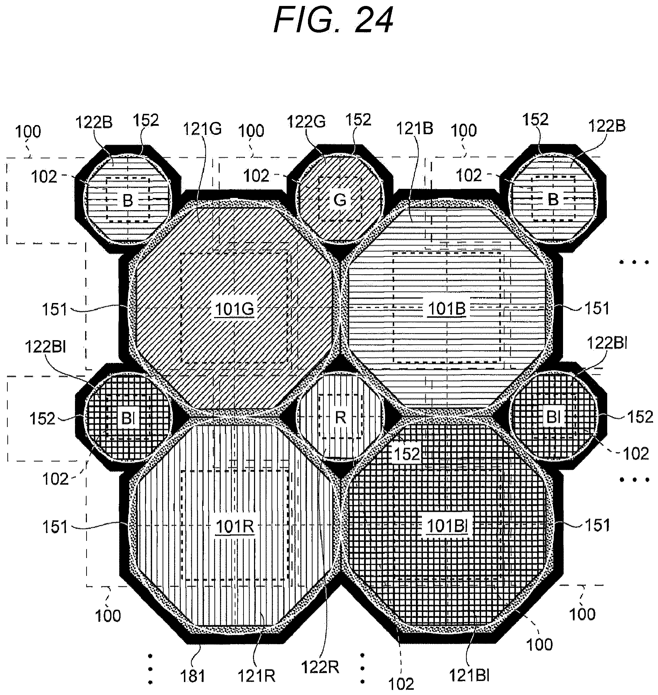

Fig. 24 is a diagram illustrating a planar layout example of unit pixels according to an eighth example of the present embodiment. As illustrated in Fig. 24, in the eighth example, to each of large pixels and small pixels, a color filter array is applied that is a combination of a total of four pixels of $2 \times 2$ pixels in which the elements constituting the unit of repetition are green, blue, red, and black (GBRBl).

Note that, in Fig. 24, a first color filter 121Bl and a second color filter 122Bl correspond to a light-shielding film. Thus, a first photoelectric conversion element 101Bl and a second photoelectric conversion element 102Bl are used as photoelectric conversion elements for reading a pixel signal of a black level.

5.9 Ninth example

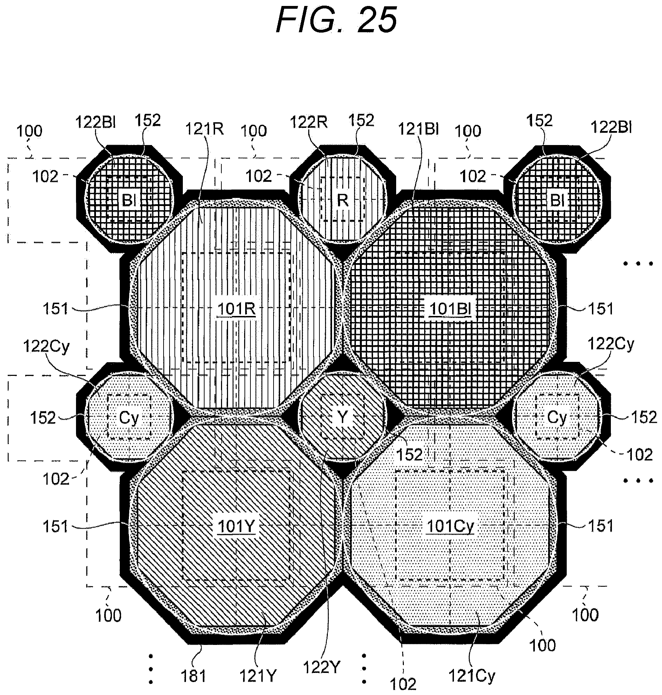

Fig. 25 is a diagram illustrating a planar layout example of unit pixels according to a ninth example of the present embodiment. As illustrated in Fig. 25, in the ninth example, to each of large pixels and small pixels, a color filter array is applied that is a combination of a total of four pixels of $2 \times 2$ pixels in which the elements constituting the unit of repetition are red, black, yellow, and cyan (RBlYCy).

5.10 Tenth example

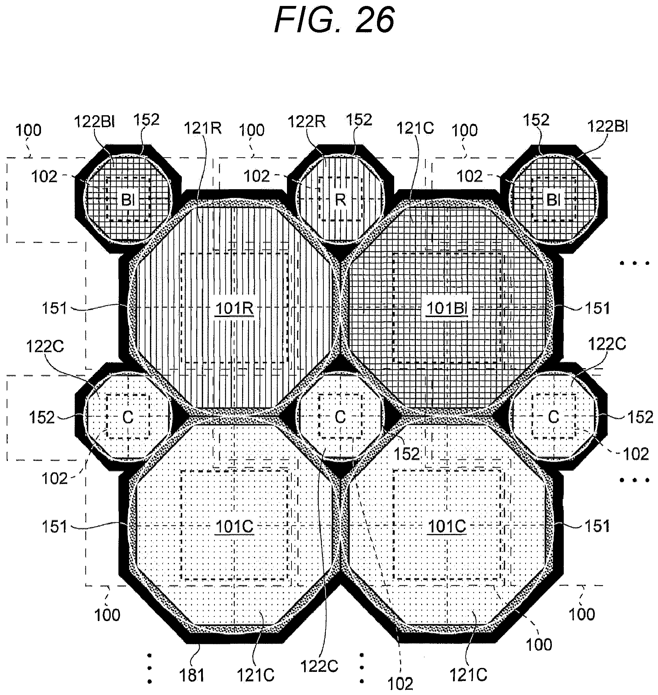

Fig. 26 is a diagram illustrating a planar layout example of unit pixels according to a tenth example of the present embodiment. As illustrated in Fig. 26, in the tenth example, to each of large pixels and small pixels, a color filter array is applied that is a combination of a total of four pixels of $2 \times 2$ pixels in which the elements constituting the unit of repetition are red, black, clear, and clear (RBlCC).

5.11 Eleventh example

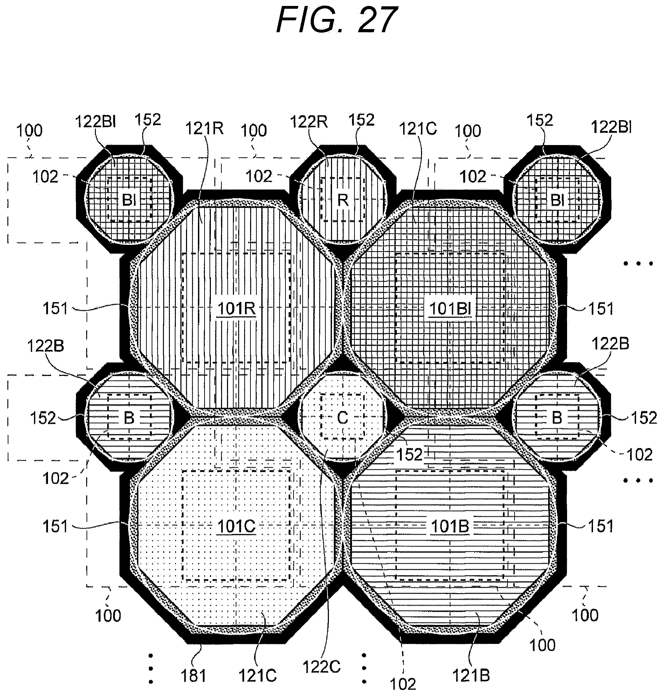

Fig. 27 is a diagram illustrating a planar layout example of unit pixels according to an eleventh example of the present embodiment. As illustrated in Fig. 27, in the eleventh example, to each of large pixels and small pixels, a color filter array is applied that is a combination of a total of four pixels of 2 × 2 pixels in which the elements constituting the unit of repetition are red, black, clear, and blue (RBICB).

5.12 Twelfth example

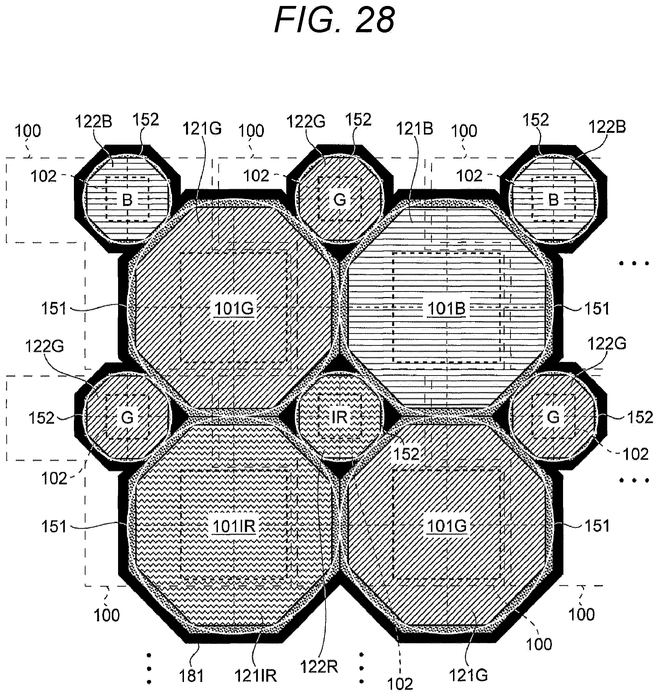

Fig. 28 is a diagram illustrating a planar layout example of unit pixels according to a twelfth example of the present embodiment. As illustrated in Fig. 28, in the twelfth example, to each of large pixels and small pixels, a color filter array is applied that is a combination of a total of four pixels of 2 × 2 pixels in which the elements constituting the unit of repetition are green, blue, infrared, and green (GBIRG).
Note that, in Fig. 28, a first color filter 121IR and a second color filter 122IR are color filters that transmit infrared light. Furthermore, a first photoelectric conversion element 101IR is a photoelectric conversion element that photoelectrically converts infrared light transmitted through the first color filter 121IR, and a second photoelectric conversion element 102IR is a photoelectric conversion element that photoelectrically converts infrared light transmitted through the second color filter 122IR.

5.13 Thirteenth example

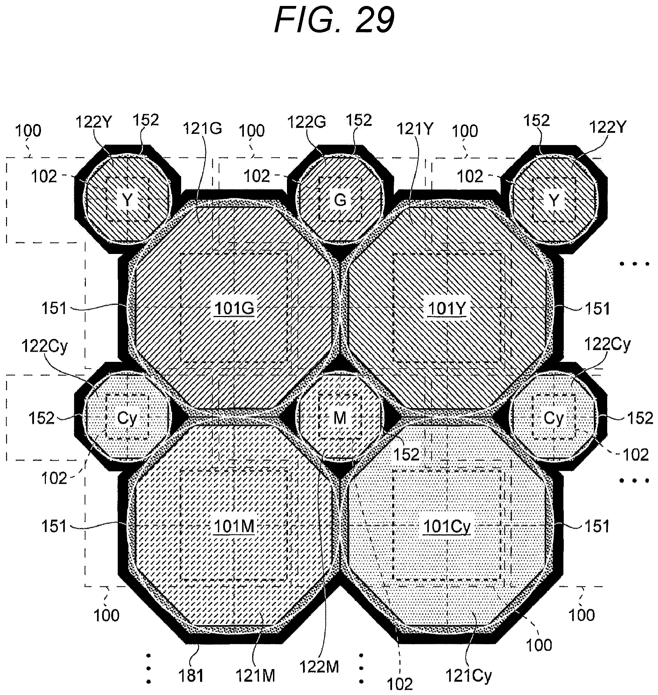

Fig. 29 is a diagram illustrating a planar layout example of unit pixels according to a thirteenth example of the present embodiment. As illustrated in Fig. 29, in the thirteenth example, to each of large pixels and small pixels, a color filter array is applied that is a combination of a total of four pixels of 2 × 2 pixels in which the elements constituting the unit of repetition are green, yellow, magenta, and cyan (GYMCy).
Note that, in Fig. 29, a first color filter 121M and a second color filter 122M are color filters that transmit a wavelength component of magenta that has a complementary color relationship with the RGB three primary colors. Furthermore, a first photoelectric conversion element 101M is a photoelectric conversion element that photoelectrically converts light transmitted through the first color filter 121M, and a second photoelectric conversion element 102M is a photoelectric conversion element that photoelectrically converts infrared light transmitted through the second color filter 122M.

5.14 Fourteenth example

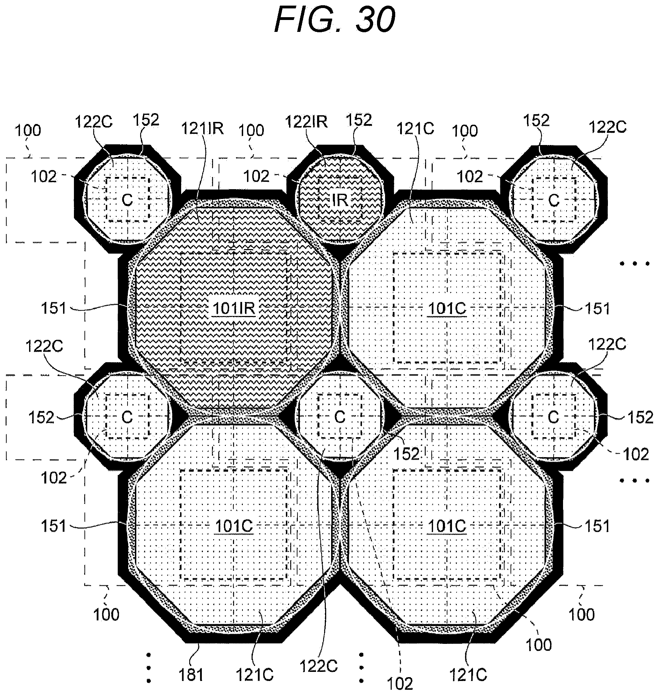

Fig. 30 is a diagram illustrating a planar layout example of unit pixels according to a fourteenth example of the present embodiment. As illustrated in Fig. 30, in the fourteenth example, to each of large pixels and small pixels, a color filter array is applied that is a combination of a total of four pixels of 2 × 2 pixels in which the elements constituting the unit of repetition are infrared, clear, clear, and clear (IRCCC).

5.15 Fifteenth example

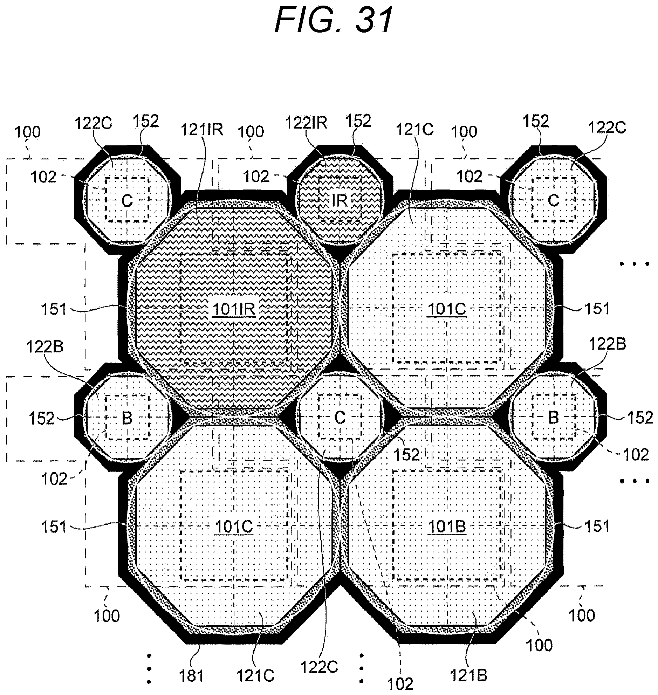

Fig. 31 is a diagram illustrating a planar layout example of unit pixels according to a fifteenth example of the present embodiment. As illustrated in Fig. 31, in the fifteenth example, to each of large pixels and small pixels, a color filter array is applied that is a combination of a total of four pixels of 2 × 2 pixels in which the elements constituting the unit of repetition are infrared, clear, clear, and blue (IRCCB).

5.16 Function and effect

Even in a case where the color filter array as exemplified above is adopted, the small pixel second photoelectric conversion element 102 that is the outflow destination of the leakage current from the large pixel is provided with the second color filter 122 that transmits the same wavelength component as that of the first color filter 121 provided for the first photoelectric conversion element 101 of the large pixel, whereby the leakage current leaked from the large pixel flows into the small pixel that generates charge on the basis of light having the same wavelength component as the large pixel, so that it is possible to reduce inflow of charge generated by light having a different wavelength component into the small pixel. As a result, influence of the leakage current on the small pixel is reduced, so that a noise ratio (S/N ratio) in image data read from the small pixel can be improved.
Since other configurations, operations, and effects may be similar to those in the above-described embodiment, detailed description thereof will be omitted here.

## 6. Sixth embodiment

In the above-described embodiments, a case has been exemplified where a large pixel having high sensitivity and a small pixel having low sensitivity by an area difference between the incident surfaces with respect to the incident light are provided and the small pixel having low sensitivity is combined with the large pixel having high sensitivity; however, the method of setting the sensitivity difference for the pixels is not limited to the method based on the area difference.

For example, by providing a difference in the impurity concentration of the photoelectric conversion element, it is possible to provide a pixel having high sensitivity (substitute for a large pixel) and a pixel having low sensitivity (substitute for a small pixel). Specifically, by increasing the impurity concentration of the first photoelectric conversion element 101 and decreasing the impurity concentration of the second photoelectric conversion element 102, it is possible to provide two pixels having different sensitivities.

Furthermore, by providing a light-shielding film on the incident surface of one pixel to set an area difference in a region where light is substantially incident, it is possible to provide a pixel having high sensitivity (no light-shielding area or small) and a pixel having low sensitivity (large light-shielding area).

Moreover, by providing a difference in the optical axis, focal length, or the like of the on-chip lenses (for example, the first on-chip lens 151 and the second on-chip lens 152) arranged on the pixels, it is possible to provide a pixel having high sensitivity and a pixel having low sensitivity.

Even in these cases, the small pixel second photoelectric conversion element 102 that is the outflow destination of the leakage current from the large pixel is provided with the second color filter 122 that transmits the same wavelength component as that of the first color filter 121 provided for the first photoelectric conversion element 101 of the large pixel, whereby the leakage current leaked from the large pixel flows into the small pixel that generates charge on the basis of light having the same wavelength component as the large pixel, so that it is possible to reduce inflow of charge generated by light having a different wavelength component into the small pixel. As a result, influence of the leakage current on the small pixel is reduced, so that a noise ratio (S/N ratio) in image data read from the small pixel can be improved.

Since other configurations, operations, and effects may be similar to those in the above-described embodiment, detailed description thereof will be omitted here.

## 7. Application example to mobile body

The technology according to the present disclosure (the present technology) can be applied to various products. The technology according to the present disclosure may be implemented as a device mounted on any type of mobile body, for example, a car, an electric car, a hybrid electric car, a motorcycle, a bicycle, a personal mobility, an airplane, a drone, a ship, a robot, or the like.

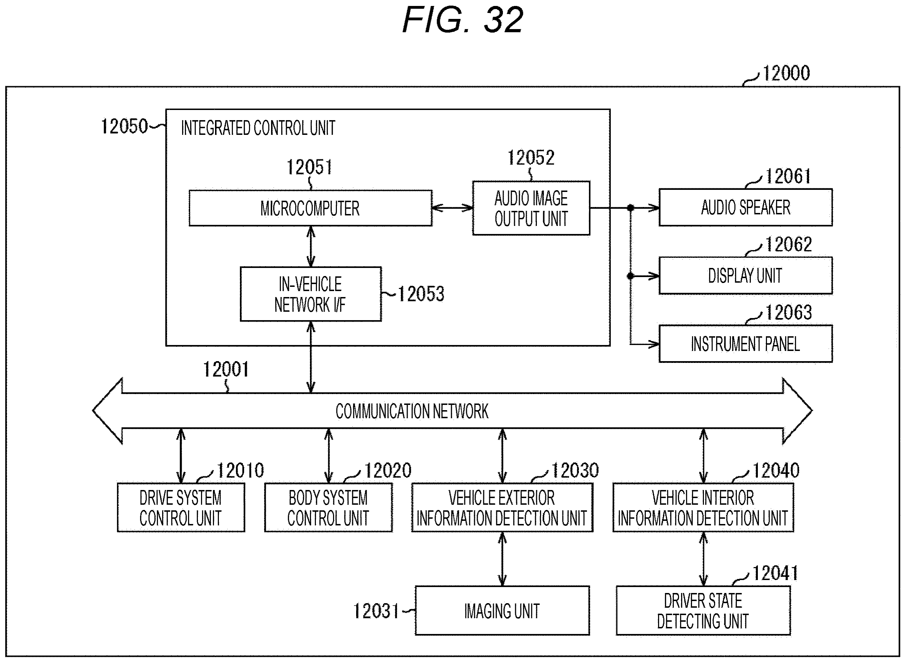

Fig. 32 is a block diagram illustrating a schematic configuration example of a vehicle control system that is an example of a mobile body control system to which the technology according to the present disclosure can be applied.

The vehicle control system 12000 includes a plurality of electronic control units connected to each other via a communication network 12001. In the example illustrated in Fig. 32, the vehicle control system 12000 includes a drive system control unit 12010, a body system control unit 12020, a vehicle exterior information detection unit 12030, a vehicle interior information detection unit 12040, and an integrated control unit 12050. Furthermore, as functional configurations of the integrated control unit 12050, a microcomputer 12051, an audio image output unit 12052, and an invehicle network interface (I/F) 12053 are illustrated.

The drive system control unit 12010 controls operation of devices related to a drive system of a vehicle in accordance with various programs. For example, the drive system control unit 12010 functions as a control device of a driving force generating device for generating driving force of the vehicle, such as an internal combustion engine or a driving motor, a driving force transmitting mechanism for transmitting driving force to wheels, a steering mechanism for adjusting a steering angle of the vehicle, a braking device for generating braking force of the vehicle, and the like.

The body system control unit 12020 controls operation of various devices equipped on the vehicle body in accordance with various programs. For example, the body system control unit 12020 functions as a control device of a keyless entry system, a smart key system, a power window device, or various lamps such as a head lamp, a back lamp, a brake lamp, a turn signal lamp, and a fog lamp. In this case, to the body system control unit 12020, a radio wave transmitted from a portable device that substitutes for a key, or signals of various switches can be input. The body system control unit 12020 accepts input of these radio waves or signals and controls a door lock device, power window device, lamp, and the like of the vehicle.

The vehicle exterior information detection unit 12030 detects information on the outside of the vehicle on which the vehicle control system 12000 is mounted. For example, an imaging unit 12031 is connected to the vehicle exterior information detection unit 12030. The vehicle exterior information detection unit 12030 causes the imaging unit 12031 to capture an image outside the vehicle and receives the image captured. The vehicle exterior information detection unit 12030 may perform object detection processing or distance detection processing on a person, a car, an obstacle, a sign, a character on a road surface, or the like, on the basis of the received image.

The imaging unit 12031 is an optical sensor that receives light and outputs an electric signal depending on an amount of light received. The imaging unit 12031 can output the electric signal as an image, or as distance measurement information. Furthermore, the light received by the imaging unit 12031 may be visible light, or invisible light such as infrared rays.

The vehicle interior information detection unit 12040 detects information on the inside of the vehicle. The vehicle interior information detection unit 12040 is connected to, for example, a driver state detecting unit 12041 that detects a state of a driver. The driver state detecting unit 12041 includes, for example, a camera that captures an image of the driver, and the vehicle interior information detection unit 12040 may calculate a degree of fatigue or a degree of concentration of the driver, or determine whether or not the driver is dozing, on the basis of the detection information input from the driver state detecting unit 12041.

The microcomputer 12051 can calculate a control target value of the driving force generating device, the steering mechanism, or the braking device on the basis of the information on the inside and outside of the vehicle acquired by the vehicle exterior information detection unit 12030 or the vehicle interior information detection unit 12040, and output a control command to the drive system control unit 12010. For example, the microcomputer 12051 can perform cooperative control aiming for implementing functions of advanced driver assistance system (ADAS) including collision avoidance or shock mitigation of the vehicle, follow-up traveling based on an inter-vehicle distance, vehicle speed maintaining traveling, vehicle collision warning, vehicle lane departure warning, or the like.

Furthermore, the microcomputer 12051 can perform cooperative control aiming for automatic driving that autonomously travels without depending on operation of the driver, or the like, by controlling the driving force generating device, the steering mechanism, the braking device, or the like on the basis of information on the periphery of the vehicle acquired by the vehicle exterior information detection unit 12030 or the vehicle interior information detection unit 12040.

Furthermore, the microcomputer 12051 can output a control command to the body system control unit 12020 on the basis of information on the outside of the vehicle acquired by the vehicle exterior information detection unit 12030. For example, the microcomputer 12051 can perform cooperative control aiming for preventing dazzling such as switching from the high beam to the low beam, by controlling the head lamp depending on a position of a preceding vehicle or an oncoming vehicle detected by the vehicle exterior information detection unit 12030.

The audio image output unit 12052 transmits at least one of audio or image output signal to an output device capable of visually or aurally notifying an occupant in the vehicle or the outside of the vehicle of information. In the example of Fig. 32, as the output device, an audio speaker 12061, a display unit 12062, and an instrument panel 12063 are exemplified. The display unit 12062 may include, for example, at least one of an on-board display or a head-up display.

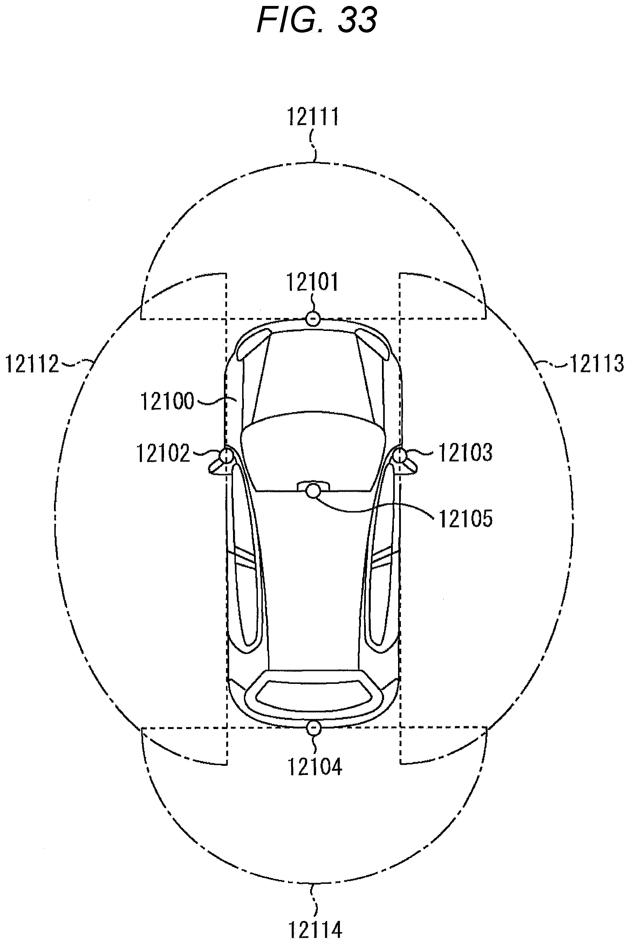

Fig. 33 is a diagram illustrating an example of installation positions of the imaging unit 12031.

In Fig. 33, as the imaging unit 12031, imaging units 12101, 12102, 12103, 12104, and 12105 are included.

Imaging units 12101, 12102, 12103, 12104, and 12105 are provided at, for example, at a position of the front nose, the side mirror, the rear bumper, the back door, the upper part of the windshield in the vehicle interior, or the like, of a vehicle 12100. The imaging unit 12101 provided at the front nose and the imaging unit 12105 provided at the upper part of the windshield in the vehicle interior mainly acquire images ahead of the vehicle 12100. The imaging units 12102 and 12103 provided at the side mirrors mainly acquire images on the sides of the vehicle 12100. The imaging unit 12104 provided at the rear bumper or the back door mainly acquires an image behind the vehicle 12100. The imaging unit 12105 provided on the upper part of the windshield in the vehicle interior is mainly used for detecting a preceding vehicle, a pedestrian, an obstacle, a traffic signal, a traffic sign, a lane, or the like.

Note that, Fig. 33 illustrates an example of imaging ranges of the imaging units 12101 to 12104. An imaging range 12111 indicates an imaging range of the imaging unit 12101 provided at the front nose, imaging ranges 12112 and 12113 respectively indicate imaging ranges of the imaging units 12102 and 12103 provided at the side mirrors, an imaging range 12114 indicates an imaging range of the imaging unit 12104 provided at the rear bumper or the back door. For example, image data captured by the imaging units 12101 to 12104 are superimposed on each other, whereby an overhead image is obtained of the vehicle 12100 viewed from above.

At least one of the imaging units 12101 to 12104 may have a function of acquiring distance information. For example, at least one of the imaging units 12101 to 12104 may be a stereo camera including a plurality of imaging elements, or may be an imaging element including pixels for phase difference detection.

For example, on the basis of the distance information obtained from the imaging units 12101 to 12104, the microcomputer 12051 obtains a distance to each three-dimensional object within the imaging ranges 12111 to 12114, and a temporal change of the distance (relative speed to the vehicle 12100), thereby being able to extract, as a preceding vehicle, a three-dimensional object that is in particular a closest three-dimensional object on a traveling path of the vehicle 12100 and traveling at a predetermined speed (for example, greater than or equal to 0 km/h) in substantially the same direction as that of the vehicle 12100. Moreover, the microcomputer 12051 can set an inter-vehicle distance to be ensured in advance in front of the preceding vehicle, and can perform automatic brake control (including follow-up stop control), automatic acceleration control (including follow-up start control), and the like. As described above, it is possible to perform cooperative control aiming for automatic driving that autonomously travels without depending on operation of the driver, or the like.

For example, on the basis of the distance information obtained from the imaging units 12101 to 12104, the microcomputer 12051 can extract three-dimensional object data regarding the three-dimensional object by classifying the objects into a two-wheeled vehicle, a regular vehicle, a large vehicle, a pedestrian, and other three-dimensional objects such as a utility pole, and use the data for automatic avoidance of obstacles. For example, the microcomputer 12051 identifies obstacles in the periphery of the vehicle 12100 into an obstacle visually recognizable to the driver of the vehicle 12100 and an obstacle difficult to visually recognize. Then, the microcomputer 12051 determines a collision risk indicating a risk of collision with each obstacle, and when the collision risk is greater than or equal to a set value and there is a possibility of collision, the microcomputer 12051 outputs an alarm to the driver via the audio speaker 12061 and the display unit 12062, or performs forced deceleration or avoidance steering via the drive system control unit 12010, thereby being able to perform driving assistance for collision avoidance.

At least one of the imaging units 12101 to 12104 may be an infrared camera that detects infrared rays. For example, the microcomputer 12051 can recognize a pedestrian by determining whether or not a pedestrian exists in the captured images of the imaging units 12101 to 12104. Such pedestrian recognition is performed by, for example, a procedure of extracting feature points in the captured images of the imaging units 12101 to 12104 as infrared cameras, and a procedure of performing pattern matching processing on a series of feature points indicating a contour of an object to determine whether or not the object is a pedestrian. When the microcomputer 12051 determines that a pedestrian exists in the captured images of the imaging units 12101 to 12104 and recognizes the pedestrian, the audio image output unit 12052 controls the display unit 12062 so that a rectangular contour line for emphasis is superimposed and displayed on the recognized pedestrian. Furthermore, the audio image output unit 12052 may control the display unit 12062 so that an icon or the like indicating the pedestrian is displayed at a desired position.

In the above, an example has been described of the vehicle control system to which the technology according to the present disclosure can be applied. The technology according to the present disclosure can be applied to the imaging unit 12031, the driver state detecting unit 12041, and the like, in the configuration described above.

In the above, the embodiments of the present disclosure have been described; however, the technical scope of the present disclosure is not limited to the above-described embodiments as they are, and various changes can be made without departing from the scope of the invention as defined by the appended claims.

Furthermore, the effects in each embodiment described in this specification are merely examples, and the effects of the present technology are not limited to them and may include other effects.

REFERENCE SIGNS LIST

10 CMOS image sensor
11 Pixel array unit
12 Vertical drive circuit
13 Column processing circuit
14 Horizontal drive circuit
15 System control unit
18 Signal processing unit
19 Data storage unit
100, 200, 300 Unit pixel
101, 101B, 101Bl, 101C, 101Cy, 101G, 101G1, 101G2, 101Gry, 101IR,
101R, 101Y First photoelectric conversion element
102 Second photoelectric conversion element
103 First transfer transistor
104 Second transfer transistor
105 Third transfer transistor
106 Fourth transfer transistor
1061 Gate electrode
107 FD part
108 Reset transistor
109 Amplification transistor
110 Selection transistor
111 Charge storage part

112, 113 Node

121, 121B, 121BI, 121C, 121Cy, 121G, 121G1, 121G2, 121Gry, 121IR, 121R, 121Y First color filter

122, 122B, 122B1, 122B2, 122BI, 122C, 122Cy, 122G, 122G1, 122G2, 122G3, 122Gry, 122IR, 122R, 122Y Second color filter

131 Current source

140 Silicon substrate

141 N- diffusion region

142 N diffusion region

143 P- diffusion region

144 P+ diffusion region

145 N+ diffusion region

146 P diffusion region

147 Silicon oxide film

148 Polysilicon electrode

151 First on-chip lens

152 Second on-chip lens

181 Inter-pixel light shielding portion

LD Pixel drive line

VSL Vertical signal line

## Claims

1. A solid-state imaging device (1) comprising:

a plurality of first photoelectric conversion elements (101) arranged in a two-dimensional lattice, the first photoelectric conversion elements (101) each having a first sensitivity;

a plurality of second photoelectric conversion elements (102) arranged in a two-dimensional lattice, the second photoelectric conversion elements (102) each having a second sensitivity lower than the first sensitivity and arranged at a corresponding one of spaces between the plurality of first photoelectric conversion elements (101) ;

a plurality of charge storage regions each including one of the plurality of second photoelectric conversion elements (102) and storing charge generated by a corresponding one of the plurality of second photoelectric conversion elements (102);

a floating diffusion region (107) that stores charge;

a first transfer transistor (103) that transfers charge generated in each of the first photoelectric conversion elements (101) to the floating diffusion region (107);

a second transfer gate (104) that transfers charge stored in each of the charge storage regions to the floating diffusion region (107) ;

an amplification transistor (109) that generates, on a signal line (VSL), a voltage signal having a voltage value corresponding to an amount of charge stored in the floating diffusion region (107);

wherein a gate electrode of the amplification transistor (109) is connected to the floating diffusion region (107);

a selection transistor (110) which is connected between a source of the amplification transistor (109) and the signal line (VSL);

a reset gate (108) that controls discharge of charge stored in the floating diffusion region (107);

a plurality of first color filters (121) provided on a one-toone basis for a light-receiving surface of each of the plurality of first photoelectric conversion elements (101); and

a plurality of second color filters (122) provided on a one-to-one basis for a light-receiving surface of each of the plurality of second photoelectric conversion elements (102),

wherein for each of the plurality of first photoelectric conversion elements (101): the second color filter (122) provided for the light-receiving surface of the second photoelectric conversion element (102) included in the charge storage region closest to the first photoelectric conversion element (101) transmit a wavelength component identical to that of the first color filter (121) provided for the light-receiving surface of the first photoelectric conversion element (101) closest to the charge storage region; and

in a case where there are two or more of candidate charge storage regions closest to the first photoelectric conversion element (101), the second color filter (122) provided for the light-receiving surface of the second photoelectric conversion element (102) included in each of the charge storage regions transmits the wavelength component identical to that of the first color filter (121) provided for the light-receiving surface of the first photoelectric conversion element (101) closest to that charge storage region out of the two or more of the candidate charge storage regions, which is closest to the selection transistor (110) and another charge storage region out of the two or more of the candidate charge storage regions, which is not closest to the selection transistor (110), is closest to the amplification transistor (109), wherein a source voltage of the selection transistor (110) is a low potential, and a drain voltage of the amplification transistor (109) is a high potential, during a storage period.

2. The solid-state imaging device (1) according to claim 1, wherein each of the plurality of charge storage regions includes, in addition to the one of the plurality of second photoelectric conversion elements (102), a charge storage part (111) that stores charge generated by the second photoelectric conversion element, and a node that connects the second photoelectric conversion element and the charge storage part (111) to each other.

3. The solid-state imaging device (1) according to claim 2, wherein the charge storage part (111) has structure including as a charge storage layer a polysilicon electrode (148) formed on a second surface that is an opposite side from a first surface of a semiconductor substrate (140) on which the first (101) and second (102) photoelectric conversion elements are formed on the first surface's side.

4. The solid-state imaging device (1) according to any one of claims 1 to 3, wherein

   the light-receiving surface of each of the plurality of first photoelectric conversion elements (101) has a first area, and
   the light-receiving surface of each of the plurality of second photoelectric conversion elements (102) has a second area smaller than the first area.

5. The solid-state imaging device (1) according to any one of claims 1 to 3, wherein

   each of the plurality of first photoelectric conversion elements (101) includes a region in which a predetermined impurity is diffused at a first concentration, and
   each of the plurality of second photoelectric conversion elements (102) includes a region in which the predetermined impurity is diffused at a second concentration lower than the first concentration.

6. The solid-state imaging device (1) according to any one of claims 1 to 5, wherein the plurality of first color filters (121) is arranged in accordance with one of a Bayer array, a quad Bayer array, or a white RGB type array.

7. The solid-state imaging device according to any one of claims 1 to 6, wherein the plurality of first color filters (121) includes

   a color filter having a broad light transmission characteristic for visible light, and/or
   a color filter that has a broad light transmission characteristic for visible light and transmits less than or equal to 80 percent (%) of visible light, and/or
   color filters that transmit wavelength components of colors having a complementary color relationship with RGB three primary colors.

8. The solid-state imaging device (1) according to any one of claims 1 to 7, wherein at least one of the plurality of first color filters (121) is a light-shielding film.

9. The solid-state imaging device (1) according to any one of claims 1 to 8, wherein the plurality of first color filters (121) includes a color filter (121R) that transmits infrared light.


**Patentansprüche**

1. Festkörperbildgebungsvorrichtung (1), umfassend:

   eine Vielzahl von ersten photoelektrischen Umwandlungselementen (101), die in einem zweidimensionalen Gitter angeordnet sind, wobei die ersten photoelektrischen Umwandlungselemente (101) jeweils eine erste Empfindlichkeit aufweisen;
   eine Vielzahl von zweiten photoelektrischen Umwandlungselementen (102), die in einem zweidimensionalen Gitter angeordnet sind, wobei die zweiten photoelektrischen Umwandlungselemente (102) jeweils eine zweite Empfindlichkeit aufweisen, die niedriger ist als die erste Empfindlichkeit, und in einem entsprechenden Zwischenraum zwischen der Vielzahl von ersten photoelektrischen Umwandlungselementen (101) angeordnet sind;

eine Vielzahl von Ladungsspeicherbereichen, von denen jeder eines aus der Vielzahl von zweiten photoelektrischen Umwandlungselementen (102) umfasst und Ladung speichert, die von einem entsprechenden aus der Vielzahl von zweiten photoelektrischen Umwandlungselementen (102) erzeugt wird;

eine floatenden Diffusionsbereich (107), der Ladung speichert;

einen ersten Transfertransistor (103), der in jedem der ersten photoelektrischen Umwandlungselemente (101) erzeugte Ladung zum floatenden Diffusionsbereich (107) überträgt;

ein zweites Transfer-Gate (104), das in jedem der Ladungsspeicherbereiche gespeicherte Ladung zum floatenden Diffusionsbereich (107) überträgt;

einen Verstärkungstransistor (109), der auf einer Signalleitung (VSL) ein Spannungssignal mit einem Spannungswert erzeugt, der einer in dem floatenden Diffusionsbereich (107) gespeicherten Ladungsmenge entspricht;

wobei eine Gate-Elektrode des Verstärkungstransistors (109) mit dem floatenden Diffusionsbereich (107) verbunden ist;

einen Auswahltransistor (110), der zwischen einer Quelle des Verstärkungstransistors (109) und der Signalleitung (VSL) angeschlossen ist;

ein Reset-Gate (108), das die Entladung der im floatenden Diffusionsbereich (107) gespeicherten Ladung steuert;

eine Vielzahl von ersten Farbfiltern (121), die auf einer Eins-zu-eins-Basis für eine Lichtempfangsoberfläche jedes der Vielzahl von ersten photoelektrischen Umwandlungselementen (101) vorgesehen sind; und

eine Vielzahl von zweiten Farbfiltern (122), die auf einer Eins-zu-eins-Basis für eine Lichtempfangsoberfläche jedes der Vielzahl von zweiten photoelektrischen Umwandlungselementen (102) vorgesehen sind,

wobei für jedes der Vielzahl von ersten photoelektrischen Umwandlungselementen (101): der zweite Farbfilter (122), der für die Lichtempfangsoberfläche des zweiten photoelektrischen Umwandlungselements (102) vorgesehen ist, das in dem Ladungsspeicherbereich enthalten ist, die dem ersten photoelektrischen Umwandlungselement (101) am nächsten liegt, eine Wellenlängenkomponente durchlässt, die mit der des ersten Farbfilters (121) identisch ist, der für die Lichtempfangsoberfläche des ersten photoelektrischen Umwandlungselements (101) vorgesehen ist, das dem Ladungsspeicherbereich am nächsten liegt; und

in einem Fall, in dem es zwei oder mehr Kandidaten-Ladungsspeicherbereiche gibt, die dem ersten photoelektrischen Umwandlungselement (101) am nächsten sind, der zweite Farbfilter (122), der für die Lichtempfangsoberfläche des zweiten photoelektrischen Umwandlungselements (102) vorgesehen ist, das in jedem der Ladungsspeicherbereiche enthalten ist, die Wellenlängenkomponente identisch zu der des ersten Farbfilters (121) überträgt, der für die Lichtempfangsoberfläche des ersten photoelektrischen Umwandlungselements (101) vorgesehen ist, das dem Ladungsspeicherbereich von den zwei oder mehr Kandidaten-Ladungsspeicherbereichen am nächsten ist, der dem Auswahltransistor (110) am nächsten ist, und ein anderer Ladungsspeicherbereich von den zwei oder mehr Kandidaten-Ladungsspeicherbereichen, der dem Auswahltransistor (110) nicht am nächsten ist, dem Verstärkungstransistor (109) am nächsten ist, wobei eine Quellenspannung des Auswahltransistors (110) ein niedriges Potential ist und eine Drain-Spannung des Verstärkungstransistors (109) während einer Speicherperiode ein hohes Potential ist.

2. Festkörperbildgebungsvorrichtung (1) nach Anspruch 1, wobei jeder der Vielzahl von Ladungsspeicherbereichen zusätzlich zu dem einen der Vielzahl von zweiten photoelektrischen Umwandlungselementen (102) einen Ladungsspeicherteil (111) umfasst, der von dem zweiten photoelektrischen Umwandlungselement erzeugte Ladung speichert, und einen Knoten, der das zweite photoelektrische Umwandlungselement und den Ladungsspeicherteil (111) miteinander verbindet.

3. Festkörperbildgebungsvorrichtung (1) nach Anspruch 2, wobei der Ladungsspeicherteil (111) eine Struktur aufweist, die als Ladungsspeicherschicht eine Polysiliziumelektrode (148) einschließt, die auf einer zweiten Oberfläche ausgebildet ist, die eine gegenüberliegende Seite einer ersten Oberfläche eines Halbleitersubstrats (140) ist, auf dem das erste (101) und das zweite (102) photoelektrische Umwandlungselement auf der Seite der ersten Oberfläche ausgebildet sind.

4. Festkörperbildgebungsvorrichtung (1) nach einem der Ansprüche 1 bis 3, wobei

die Lichtempfangsoberfläche jedes der Vielzahl von ersten photoelektrischen Umwandlungselementen (101) eine erste Fläche aufweist, und
die Lichtempfangsoberfläche jedes der Vielzahl von zweiten photoelektrischen Umwandlungselementen (102) eine zweite Fläche aufweist, die kleiner ist als die erste Fläche.

**5.** Festkörperbildgebungsvorrichtung (1) nach einem der Ansprüche 1 bis 3, wobei

jedes der Vielzahl erster photoelektrischer Umwandlungselemente (101) einen Bereich einschließt, in den eine vorbestimmte Verunreinigung in einer ersten Konzentration diffundiert ist, und
jedes der Vielzahl von zweiten photoelektrischen Umwandlungselementen (102) einen Bereich einschließt, in dem die vorgegebene Verunreinigung in einer zweiten Konzentration diffundiert ist, die niedriger als die erste Konzentration ist.

**6.** Festkörperbildgebungsvorrichtung (1) nach einem der Ansprüche 1 bis 5, wobei die Vielzahl der ersten Farbfilter (121) entsprechend einem Bayer-Array, einem Quad-Bayer-Array oder einem Array vom Typ Weiß-RGB angeordnet ist.

**7.** Festkörperbildgebungsvorrichtung nach einem der Ansprüche 1 bis 6, wobei die Vielzahl der ersten Farbfilter (121) einschließt

ein Farbfilter mit einer breiten Lichtdurchlässigkeitscharakteristik für sichtbares Licht, und/oder
einen Farbfilter, der eine breite Lichtdurchlässigkeitscharakteristik für sichtbares Licht aufweist und weniger als oder gleich 80 Prozent (%) des sichtbaren Lichts durchlässt, und/oder
Farbfilter, die Wellenlängenkomponenten von Farben übertragen, die in einer komplementären Farbbeziehung zu den drei RGB-Primärfarben stehen.

**8.** Festkörperbildgebungsvorrichtung (1) nach einem der Ansprüche 1 bis 7, wobei mindestens einer der Vielzahl von ersten Farbfiltern (121) ein Lichtschutzfilm ist.

**9.** Festkörperbildgebungsvorrichtung (1) nach einem der Ansprüche 1 bis 8, wobei die Vielzahl der ersten Farbfilter (121) einen Farbfilter (121R) einschließt, der Infrarotlicht durchlässt.

**Revendications**

**1.** Dispositif d'imagerie à semi-conducteurs (1) comprenant :

une pluralité de premiers éléments de conversion photoélectrique (101) agencés en un réseau bidimensionnel, les premiers éléments de conversion photoélectrique (101) ayant chacun une première sensibilité ;
une pluralité de seconds éléments de conversion photoélectrique (102) agencés en un réseau bidimensionnel, les seconds éléments de conversion photoélectrique (102) ayant chacun une seconde sensibilité inférieure à la première sensibilité et agencés au niveau d'un espace correspondant parmi des espaces entre la pluralité de premiers éléments de conversion photoélectrique (101) ;
une pluralité de régions de stockage de charge comportant chacune l'un de la pluralité de seconds éléments de conversion photoélectrique (102) et stockant une charge générée par un élément correspondant de la pluralité de seconds éléments de conversion photoélectrique (102) ;
une région de diffusion flottante (107) qui stocke une charge ;
un premier transistor de transfert (103) qui transfère une charge générée dans chacun des premiers éléments de conversion photoélectrique (101) vers la région de diffusion flottante (107) ;
une seconde grille de transfert (104) qui transfère une charge stockée dans chacune des régions de stockage de charge vers la région de diffusion flottante (107) ;
un transistor d'amplification (109) qui génère, sur une ligne de signal (VSL), un signal de tension ayant une valeur de tension correspondant à une quantité de charge stockée dans la région de diffusion flottante (107) ;
dans lequel une électrode de grille du transistor d'amplification (109) est connectée à la région de diffusion flottante (107) ;
un transistor de sélection (110) qui est connecté entre une source du transistor d'amplification (109) et la ligne de signal (VSL) ;
une grille de réinitialisation (108) qui commande une décharge de la charge stockée dans la région de diffusion flottante (107) ;
une pluralité de premiers filtres de couleur (121) prévus un à un pour une surface de réception de lumière de chacun de la pluralité de premiers éléments de conversion photoélectrique (101) ; et
une pluralité de seconds filtres de couleur (122) prévus un à un pour une surface de réception de lumière de chacun de la pluralité de seconds éléments de conversion photoélectrique (102),

dans lequel, pour chacun de la pluralité de premiers éléments de conversion photoélectrique (101) : le second filtre de couleur (122) prévu pour la surface de réception de lumière du second élément de conversion photoélectrique (102) inclus dans la zone de stockage de charge la plus proche du premier élément de conversion photoélectrique (101) transmet une composante de longueur d'onde identique à celle du premier filtre de couleur (121) prévu pour la surface de réception de lumière du premier élément de conversion photoélectrique (101) le plus proche de la zone de stockage de charge ; et

dans un cas où il y a au deux régions, ou plus, de stockage de charge candidates les plus proches du premier élément de conversion photoélectrique (101), le second filtre de couleur (122) prévu pour la surface de réception de lumière du second élément de conversion photoélectrique (102) inclus dans chacune des régions de stockage de charge transmet la composante de longueur d'onde identique à celle du premier filtre de couleur (121) prévu pour la surface de réception de lumière du premier élément de conversion photoélectrique (101) le plus proche de cette région de stockage de charge parmi les deux régions, ou plus, de stockage de charge candidates, qui est la plus proche du transistor de sélection (110) et une autre région de stockage de charge parmi les deux régions, ou plus, de stockage de charge candidates, qui n'est pas la plus proche du transistor de sélection (110), est la plus proche du transistor d'amplification (109), dans lequel une tension de source du transistor de sélection (110) est un potentiel bas, et une tension de drain du transistor d'amplification (109) est un potentiel élevé, pendant une période de stockage.

2. Dispositif d'imagerie à semi-conducteurs (1) selon la revendication 1, dans lequel chacune de la pluralité de régions de stockage de charge comporte, en plus de l'un de la pluralité de seconds éléments de conversion photoélectrique (102), une partie de stockage de charge (111) qui stocke une charge générée par le second élément de conversion photoélectrique, et un noeud qui connecte le second élément de conversion photoélectrique et la partie de stockage de charge (111) l'un à l'autre.

3. Dispositif d'imagerie à semi-conducteurs (1) selon la revendication 2, dans lequel la partie de stockage de charge (111) a une structure comportant comme couche de stockage de charge une électrode de polysilicium (148) formée sur une seconde surface qui est un côté opposé à une première surface d'un substrat semiconducteur (140) sur lequel les premier (101) et second (102) éléments de conversion photoélectrique sont formés sur le côté de la première surface.

4. Dispositif d'imagerie à semi-conducteurs (1) selon l'une quelconque des revendications 1 à 3, dans lequel

la surface de réception de lumière de chacun de la pluralité de premiers éléments de conversion photoélectrique (101) a une première surface, et

la surface de réception de lumière de chacun de la pluralité de seconds éléments de conversion photoélectrique (102) a une seconde surface plus petite que la première surface.

5. Dispositif d'imagerie à semi-conducteurs (1) selon l'une quelconque des revendications 1 à 3, dans lequel

chacun de la pluralité de premiers éléments de conversion photoélectrique (101) comporte une région dans laquelle une impureté prédéterminée est diffusée à une première concentration, et

chacun de la pluralité de seconds éléments de conversion photoélectrique (102) comporte une région dans laquelle l'impureté prédéterminée est diffusée à une seconde concentration inférieure à la première concentration.

6. Dispositif d'imagerie à semi-conducteurs (1) selon l'une quelconque des revendications 1 à 5, dans lequel la pluralité de premiers filtres de couleur (121) est agencée selon l'un parmi un réseau de Bayer, un réseau de Bayer quadruple, ou un réseau de type blanc RVB.

7. Dispositif d'imagerie à semi-conducteurs selon l'une quelconque des revendications 1 à 6, dans lequel la pluralité de premiers filtres de couleur (121) comporte

un filtre de couleur ayant une caractéristique de transmission de lumière large pour la lumière visible, et/ou

un filtre de couleur qui a une caractéristique de transmission de lumière large pour la lumière visible et transmet 80 pour cent (%) ou moins de lumière visible, et/ou

des filtres de couleur qui transmettent des composantes de longueur d'onde de couleurs ayant une relation de couleur complémentaire avec les trois couleurs primaires RVB.

**8.** Dispositif d'imagerie à semi-conducteurs (1) selon l'une quelconque des revendications 1 à 7, dans lequel au moins l'un de la pluralité de premiers filtres de couleur (121) est un film de protection contre la lumière.

**9.** Dispositif d'imagerie à semi-conducteurs (1) selon l'une quelconque des revendications 1 à 8, dans lequel la pluralité de premiers filtres de couleur (121) comporte un filtre de couleur (121R) qui transmet la lumière infrarouge.

# FIG. 1

12  LD  100  11  10

VERTICAL DRIVE CIRCUIT

PIXEL ARRAY UNIT

VSL  18

SYSTEM CONTROL UNIT

COLUMN PROCESSING CIRCUIT

SIGNAL PROCESSING UNIT

OUTPUT IMAGE

13

HORIZONTAL DRIVE CIRCUIT

DATA STORAGE UNIT

14

19

15

# FIG. 2

# FIG. 3

# FIG. 4

# FIG. 5

# FIG. 6

# FIG. 7

## FIG. 8

| R | Gr | R | Gr | ··· |
| Gb | B | Gb | B | ··· |
| R | Gr | R | Gr | ··· |
| Gb | B | Gb | B | ··· |

## FIG. 9

| G | B | G | G | R | G | ··· |
| R | G | R | B | G | B | ··· |
| G | B | G | G | R | G | ··· |
| G | R | G | G | B | G | ··· |
| B | G | B | R | G | R | ··· |
| G | R | G | G | B | G | ··· |

# FIG. 10

| R | R | Gr | Gr | R | R | Gr | Gr | · · · |
|---|---|----|----|---|---|----|----|-------|
| R | R | Gr | Gr | R | R | Gr | Gr | · · · |
| Gb | Gb | B | B | Gb | Gb | B | B | · · · |
| Gb | Gb | B | B | Gb | Gb | B | B | · · · |
| R | R | Gr | Gr | R | R | Gr | Gr | · · · |
| R | R | Gr | Gr | R | R | Gr | Gr | · · · |
| Gb | Gb | B | B | Gb | Gb | B | B | · · · |
| Gb | Gb | B | B | Gb | Gb | B | B | · · · |

# FIG. 11

| B | W | R | W | B | W | R | W | · · · |
|---|---|---|---|---|---|---|---|-------|
| W | G | W | G | W | G | W | G | · · · |
| R | W | B | W | R | W | B | W | · · · |
| W | G | W | G | W | G | W | G | · · · |
| B | W | R | W | B | W | R | W | · · · |
| W | G | W | G | W | G | W | G | · · · |
| R | W | B | W | R | W | B | W | · · · |
| W | G | W | G | W | G | W | G | · · · |

# FIG. 12

# FIG. 13

# FIG. 14

# FIG. 15

# FIG. 16

# FIG. 17

# FIG. 18

# FIG. 19

# FIG. 20

# FIG. 21

# FIG. 22

# FIG. 23

# FIG. 24

# FIG. 25

# FIG. 26

# FIG. 27

# FIG. 28

# FIG. 29

# FIG. 30

# FIG. 31

# FIG. 32

EP 3 896 966 B1

# FIG. 33

**EP 3 896 966 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017163010 A
- US 2011140182 A1
- WO 2017154605 A1